(19) Europäisches Patentamt
European Patent Office
Office européen des brevets

(11) **EP 2 312 593 A1**

(12) **EUROPEAN PATENT APPLICATION**
published in accordance with Art. 153(4) EPC

(43) Date of publication:
**20.04.2011 Bulletin 2011/16**

(21) Application number: **09804963.8**

(22) Date of filing: **04.08.2009**

(51) Int Cl.:
***H01B 17/56*** *(2006.01)* ***B32B 15/08*** *(2006.01)*
***H01B 17/62*** *(2006.01)*

(86) International application number:
**PCT/JP2009/063794**

(87) International publication number:
**WO 2010/016480 (11.02.2010 Gazette 2010/06)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **07.08.2008 JP 2008204531**
**09.12.2008 JP 2008313268**
**06.01.2009 JP 2009001097**
**27.02.2009 JP 2009046692**

(71) Applicant: **Sekisui Chemical Co., Ltd.**
**Osaka 530-8565 (JP)**

(72) Inventors:
- **MAENAKA, Hiroshi**
  **Mishima-gun**
  **Osaka 618-8589 (JP)**
- **HIGUCHI, Isao**
  **Mishima-gun**
  **Osaka 618-8589 (JP)**
- **KUSAKA, Yasunari**
  **Mishima-gun**
  **Osaka 618-8589 (JP)**
- **AOYAMA, Takuji**
  **Mishima-gun**
  **Osaka 618-8589 (JP)**
- **WATANABE, Takashi**
  **Mishima-gun**
  **Osaka 618-8589 (JP)**
- **NAKAJIMA, Daisuke**
  **Mishima-gun**
  **Osaka 618-8589 (JP)**
- **TAKAHASHI, Ryousuke**
  **Mishima-gun**
  **Osaka 618-8589 (JP)**

(74) Representative: **Merkle, Gebhard**
**TER MEER STEINMEISTER & PARTNER GbR,**
**Patentanwälte**
**Mauerkircherstrasse 45**
**81679 München (DE)**

# (54) INSULATING SHEET AND MULTILAYER STRUCTURE

(57) The present invention provides an insulating sheet which is excellent in handleability when it is uncured, and provides a cured product excellent in dielectric breakdown characteristics, thermal conductivity, heat resistance, acid resistance, and processability, and a multilayer structure produced by the use of the insulating sheet. The insulating sheet comprising: (A) a polymer having a weight average molecular weight of 10, 000 or more; (B) at least one of an epoxy resin (B1) having a weight average molecular weight of less than 10,000 and an oxetane resin (B2) having a weight average molecular weight of less than 10,000; (C) a curing agent; and (D) at least one of magnesium carbonate anhydrous (D1) represented by $MgCO_3$ and containing no crystal water and a coated body (D2) obtainable by coating the surface of the magnesium carbonate anhydrous (D1) with an organic resin, a silicone resin, or silica.

[FIG. 1]

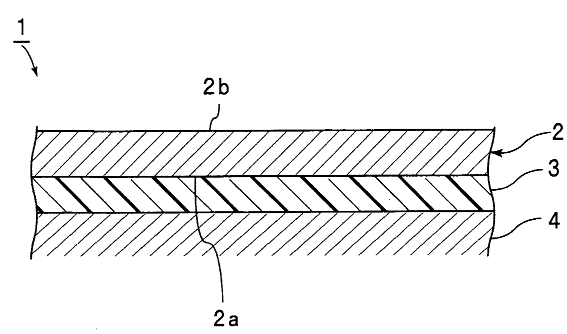


EP 2 312 593 A1

## Description

### TECHNICAL FIELD

The present invention relates to an insulating sheet used for bonding a heat conductor having a thermal conductivity of 10 W/m·K or higher to an electrically conductive layer. Specifically, the present invention relates to an insulating sheet which is excellent in handleability when it is uncured, and provides a cured product excellent in dielectric breakdown characteristics, thermal conductivity, heat resistance, acid resistance, and processability, and a multilayer structure produced by the use of the insulating sheet.

### BACKGROUND ART

Electrical apparatuses have recently been downsized and allowed to have higher performance, and thus electronic components have been mounted with a higher package density. Such a situation makes it much important to dissipate heat generated from the electronic components. As a widely employed heat dissipation method, a heat conductor having high heat-dissipation capability and a thermal conductivity of 10 W/m·K or higher, such as aluminum, is bonded to a heat source. For bonding the heat conductor to the heat source, an insulating adhesive material is used. The insulating adhesive material is required to have a high thermal conductivity.
As one example of the insulating adhesive material, Patent Document 1 discloses an insulating adhesive sheet in which glass cloth is impregnated with an adhesive composition containing an epoxy resin, a curing agent for an epoxy resin, a curing accelerator, an elastomer, and an inorganic filler.
Insulating adhesive materials free from glass cloth are also known. For example, Patent Document 2 discloses in EXAMPLES an insulating adhesive containing a bisphenol A epoxy resin, a phenoxy resin, phenol novolac, 1-cyanoethyl-2-phenylimidazole, γ-glycidoxypropyltrimethoxysilane, and alumina. Patent Document 2 discloses, as examples of the curing agent for an epoxy resin, tertiary amines, acid anhydrides, imidazole compounds, polyphenol resins, and mask-isocyanates.
Patent Document 1: JP 2006-342238 A
Patent Document 2: JP H08-332696 A

### SUMMARY OF INVENTION

### PROBLEM WHICH THE INVENTION IS TO SOLVE

The insulating adhesive sheet of Patent Document 1 is formed by the use of glass cloth for higher handleability. In the case of using glass cloth, it is difficult to make an insulating adhesive sheet thin, and it is also difficult to perform various processing such as laser processing and drill piercing on the insulating adhesive sheet. Further, a cured product of a glass cloth-containing insulating adhesive sheet has a relatively low thermal conductivity, and thus it has insufficient heat dissipation capability in some cases. In addition, impregnation of the glass cloth with the adhesive composition requires special equipment.
The insulating adhesive of Patent Document 2 is formed without glass cloth, so that it does not have the aforementioned problems. However, this insulating adhesive itself does not have self supportability when it is uncured. Thus, the handleability of the insulating adhesive is poor.
An object of the present invention is to provide an insulating sheet which is used for bonding a heat conductor having a thermal conductivity of 10 W/m·K or higher to an electrically conductive layer, is excellent in handleability when it is uncured, and provides a cured product excellent in dielectric breakdown characteristics, thermal conductivity, heat resistance, acid resistance, and processability. Another object of the present invention is to provide a multilayer structure formed by the use of the insulating sheet.

### MEANS FOR SOLVING THE PROBLEM

The present invention provides an insulating sheet used for bonding a heat conductor having a thermal conductivity of 10 W/m·K or higher to an electrically conductive layer, comprising: (A) a polymer having a weight average molecular weight of 10,000 or more; (B) at least one of an epoxy resin (B1) having a weight average molecular weight of less than 10,000 and an oxetane resin (B2) having a weight average molecular weight of less than 10,000; (C) a curing agent; and (D) at least one of magnesium carbonate anhydrous (D1) represented by $MgCO_3$ and containing no crystal water and a coated body (D2) obtainable by coating the surface of the magnesium carbonate anhydrous (D1)

with an organic resin, a silicone resin, or silica.

In a specific aspect of the insulating sheet according to the present invention, the insulating sheet further comprises (G) an inorganic filler other than the substance (D).

In another specific aspect of the insulating sheet according to the present invention, the inorganic filler (G) is at least one substance selected from the group consisting of alumina, silica, boron nitride, aluminum nitride, silicon nitride, silicon carbide, zinc oxide, magnesium oxide, talc, mica, and hydrotalcite.

In another specific aspect of the insulating sheet according to the present invention, the polymer (A) has an aromatic skeleton and a weight average molecular weight of 30,000 or more.

In another specific aspect of the insulating sheet according to the present invention, the curing agent (C) is a phenol resin, or an acid anhydride having an aromatic skeleton or an alicyclic skeleton, a hydrogenated product of the acid anhydride, or a modified product of the acid anhydride.

In another specific aspect of the insulating sheet according to the present invention, the resin (B) contains at least one of an epoxy monomer (B1b) having an aromatic skeleton and a weight average molecular weight of 600 or less and an oxetane monomer (B2b) having an aromatic skeleton and a weight average molecular weight of 600 or less.

In still another specific aspect of the insulating sheet according to the present invention, the insulating sheet contains 20 to 60% by weight of the polymer (A) and 10 to 60% by weight of the monomer (B) in 100% by weight of all resin components including the polymer (A), the monomer (B), and the curing agent (C) so that the total amount of the polymer (A) and the monomer (B) is less than 100% by weight, when the insulating sheet is uncured, the insulating sheet has a glass transition temperature of 25˚C or lower.

In still another specific aspect of the insulating sheet according to the present invention, the substance (D) is at least one substance (Dd1) of spherical magnesium carbonate anhydrous (D1d1) represented by $MgCO_3$ and containing no crystal water and a coated body (D2d1) obtainable by coating the surface of the spherical magnesium carbonate anhydrous (D1d1) with an organic resin, a silicone resin, or silica.

In still another specific aspect of the insulating sheet according to the present invention, the substance (D) is at least one substance (Dd2) of substantially-polyhedral magnesium carbonate anhydrous (D1d2) represented by $MgCO_3$ and containing no crystal water and a coated body (D2d2) obtainable by coating the surface of the substantially-polyhedral magnesium carbonate anhydrous (D1d2) with an organic resin, a silicone resin, or silica, the insulating sheet further comprises an inorganic filler (G) other than the substance (D) and the inorganic filler (G) is a plate filler.

The substance (Dd2) preferably has an average particle size in the range of 0.1 to 40 $\mu$m and the plate filler has the average length of 0.1 to 10 $\mu$m. The insulating sheet preferably contains the substance (Dd2) and the plate filler at a volume ratio of 70:30 to 99:1, and the total amount of the substance (Dd2) and the plate filler contained in the insulating sheet is preferably 60 to 90% by volume. Combination use of a plate filler and a substance (Dd2) having such shape, size, kind and the like efficiently effectively allows the cured product of the insulating sheet to have higher heat dissipation capability.

In still another specific aspect of the insulating sheet according to the present invention, the insulating sheet further comprises (F) a dispersant having a hydrogen-bonding functional group containing a hydrogen atom. The hydrogen-bonding functional group containing a hydrogen atom in the dispersant (F) preferably has a pKa of 2 to 10. Use of such a dispersant (F) allows the cured product of the insulating sheet to have much higher thermal conductivity and dielectric breakdown characteristics.

The polymer (A) preferably has a hydrogen-bonding functional group containing a hydrogen atom. The hydrogen-bonding functional group containing a hydrogen atom in the polymer (A) is preferably at least one functional group selected from the group consisting of a phosphate group, a carboxyl group, and a sulfonate group. Use of such a polymer (A) further allows the cured product of the insulating sheet to have much higher dielectric breakdown characteristics and thermal conductivity.

The polymer (A) is preferably a phenoxy resin. Use of a phenoxy resin allows the cured product of the insulating sheet to have much higher heat resistance. Further, the phenoxy resin preferably has a glass transition temperature of 95˚C or higher. In this case, the resin is much more prevented from heat degradation.

The curing agent (C) is preferably a first acid anhydride having a polyalicyclic skeleton, a hydrogenated product of the first acid anhydride, or a modified product of the first acid anhydride, or a second acid anhydride having an alicyclic skeleton formed by addition reaction between a terpene compound and maleic anhydride, a hydrogenated product of the second acid anhydride, or a modified product of the second acid anhydride. Further, the curing agent (C) is preferably an acid anhydride represented by any one of the following formulas (1) to (3). Use of these preferable curing agents (C) allows the insulating sheet to have much higher flexibility, moisture resistance, or adhesion.

[Chem. 1]

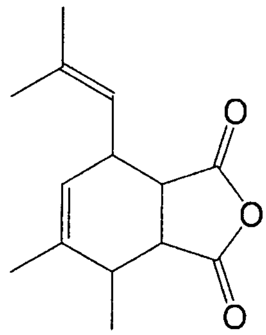

(1)

[Chem. 2]

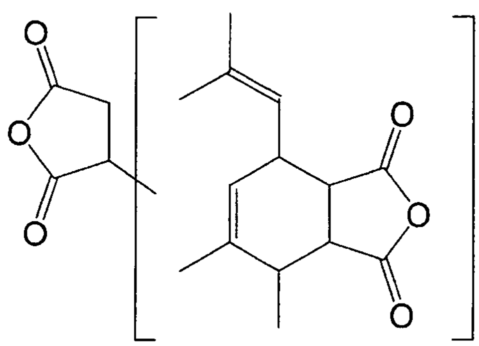

(2)

[Chem. 3]

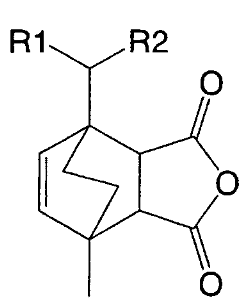

(3)

In the formula (3), R1 and R2 each represent hydrogen, a C1-C5 alkyl group, or a hydroxy group.

The curing agent (C) is preferably a phenol resin having a melamine skeleton or a triazine skeleton, or a phenol

resin having an allyl group. Use of this preferable curing agent (C) allows the cured product of the insulating sheet to have much higher flexibility and flame retardancy.

The resin (B) preferably has a hydroxy group equivalent of 6000 or more. This allows the insulating sheet to have much higher handleability, when it is uncured. In addition, further curing of the insulating sheet in storage does not go so far as causing a crack in the insulating sheet during handling thereof, which allows the insulating sheet to have higher storage stability when it is uncured.

In another specific aspect of the insulating sheet according to the present invention, the insulating sheet has a glass transition temperature of 25˚C or lower and a bending modulus at 25˚C of 10 to 1,000 MPa when it is uncured. After the insulating sheet is cured, a cured product of the insulating sheet has a bending modulus at 25˚C of 1,000 to 50, 000 MPa. The insulating sheet has a tanδ of 0.1 to 1.0 at 25˚C when it is uncured. When the uncured insulating sheet is heated from 25˚C to 250˚C, the insulating sheet has a maximum tanδ of 1.0 to 5.0. Each of the tanδ is measured with a rotating dynamic viscoelasticity measuring apparatus.

A multilayer structure according to the present invention includes: a heat conductor having a thermal conductivity of 10 W/m·K or higher; an insulating layer laminated on at least one side of the heat conductor; and an electrically conductive layer laminated on the insulating layer on the other side of the insulating sheet. The insulating layer is formed by curing the insulating sheet according to the present invention.

In the multilayer structure of the present invention, the heat conductor is preferably made of metal.

### Effects of the invention

The components of (A) to (D) contained in the insulating sheet according to the present invention allows the insulating sheet to have higher handleability when it is uncured. In addition, these components also allows the cured product obtainable by curing the insulating sheet according to the present invention to have higher dielectric breakdown characteristics, thermal conductivity, heat resistance, acid resistance, and processability.

The multilayer structure according to the present invention includes the electrically conductive layer laminated on at least one side of the heat conductor having a thermal conductivity of 10 W/m·K or higher via the insulating layer. The insulating layer is formed by curing the insulating sheet according to the present invention, so that heat from the side of the electrically conductive layer is likely to be transmitted to the heat conductor through the insulating layer. Thus, the heat is efficiently dissipated through the heat conductor.

## BRIEF DESCRIPTION OF THE DRAWING

Fig. 1 is a partially-cutout cross-sectional front view schematically showing a multilayer structure according to one embodiment of the present invention.

## MODE FOR CARRYING OUT THE INVENTION

The present inventors have found that the composition containing: (A) a polymer having a weight average molecular weight of 10, 000 or more; (B) at least one of an epoxy resin (B1) having a weight average molecular weight of less than 10,000 and an oxetane resin (B2) having a weight average molecular weight of less than 10,000; (C) a curing agent; and (D) at least one of magnesium carbonate anhydrous (D1) represented by $MgCO_3$ and containing no crystal water and a coated body (D2) obtainable by coating the surface of the magnesium carbonate anhydrous (D1) with an organic resin, a silicone resin, or silica allows the insulating sheet to have higher handleability when it is uncured, and the cured product of the insulating sheet to have higher dielectric breakdown characteristics, thermal conductivity, heat resistance, acid resistance, and processability.

The present inventors have further found out that combination use of the substance (D) and an inorganic filler (G) other than the substance (D) allows the cured product of the insulating sheet to have still higher thermal conductivity while maintaining its high processability.

In addition, the present inventors have also found that, in the case that the substance (D) is at least one substance (Dd1) of spherical magnesium carbonate anhydrous (D1d1) represented by $MgCO_3$ and containing no crystal water and a coated body (D2d1) obtainable by coating the surface of the spherical magnesium carbonate anhydrous (D1d1) with an organic resin, a silicone resin, or silica, it is possible to fill the substance (Dd1) into the insulating sheet at a high density and improve the processability of the cured product of the insulating sheet. The substance (Dd1) filling the insulating sheet at a high density allows the cured product of the insulating sheet to have still higher heat dissipation capability.

In the following, the present invention is specifically described.

The insulating sheet according to the present invention comprises (A) a polymer having an aromatic skeleton and a weight average molecular weight of 10,000 or more; (B) at least one of an epoxy resin (B1) having a weight

average molecular weight of less than 10, 000 and an oxetane resin (B2) having a weight average molecular weight of less than 10,000; (C) a curing agent; and (D) at least one of magnesium carbonate anhydrous (D1) represented by $MgCO_3$ and containing no crystal water and a coated body (D2) obtainable by coating the surface of the magnesium carbonate anhydrous (D1) with an organic resin, a silicone resin, or silica.

(Polymer (A))

The polymer (A) contained in the insulating sheet according to the present invention is not particularly limited as long as it has a weight average molecular weight of 10,000 or more. The polymer (A) preferably has an aromatic skeleton. In the case of having an aromatic skeleton, the polymer (A) may contain an aromatic skeleton at any moiety of the whole polymer, and may contain an aromatic skeleton in the main chain skeleton or in the side chain. The polymer (A) preferably contains an aromatic skeleton in the main chain skeleton. In this case, the cured product of the insulating sheet is allowed to have much higher heat resistance. The polymer (A) may be used alone, or two or more polymers (A) may be used in combination.

The aforementioned aromatic skeleton is not particularly limited. Specific examples of the aromatic skeleton include a naphthalene skeleton, a fluorene skeleton, a biphenyl skeleton, an anthracene skeleton, a pyrene skeleton, a xanthene skeleton, an adamantine skeleton, and a bisphenol A skeleton. In particular, a biphenyl skeleton or a fluorene skeleton is preferable. In this case, the cured product of the insulating sheet is allowed to have much higher heat resistance.

The polymer (A) may be a thermoplastic resin or a thermosetting resin.

The thermoplastic resin and the thermosetting resin are not particularly limited. Examples of the thermoplastic resin and the thermosetting resin include thermoplastic resins such as polyphenylene sulfide, polyarylate, polysulfone, polyethersulfone, polyetheretherketone, and polyetherketone. In addition, the examples of the thermoplastic resin and the thermosetting resin further include heat-resistant resins, which are so-called super engineering plastics, such as thermoplastic polyimide, thermosetting polyimide, benzoxazine, and a reaction product of polybenzoxazole and benzoxazine. Each of the thermoplastic resins may be used alone, or two or more of these may be used in combination. Also, each of the thermosetting resins may be used alone, or two or more of these may be used in combination. Either one of a thermoplastic resin or a thermosetting resin may be used, or both of a thermoplastic resin and a thermosetting resin may be used in combination.

The polymer (A) is preferably a styrenic polymer, a (meth) acrylic polymer, or a phenoxy resin, and more preferably a phenoxy resin. In this case, the cured product of the insulating sheet is allowed to have resistance against oxidation aging and much higher heat resistance.

Specific examples of the styrenic polymer include polymers containing only styrenic monomers or copolymers containing styrenic monomers and acrylic monomers. Particularly preferable are styrenic polymers having a styrene-glycidyl methacrylate structure.

Examples of the styrenic monomer include styrene, o-methylstyrene, m-methylstyrene, p-methylstyrene, p-methoxystyrene, p-phenylstyrene, p-chlorostyrene, p-ethylstyrene, p-n-butylstyrene, p-tert-butylstyrene, p-n-hexylstyrene, p-n-octylstyrene, p-n-nonylstyrene, p-n-decylstyrene, p-n-dodecylstyrene, 2,4-dimethylstyrene, and 3,4-dichlorostyrene.

Examples of the acrylic monomer include acrylic acid, methacrylic acid, methyl acrylate, ethyl acrylate, butyl acrylate, 2-ethylhexyl acrylate, cyclohexyl acrylate, phenyl acrylate, methyl methacrylate, ethyl methacrylate, butyl methacrylate, hexyl methacrylate, 2-ethylhexyl methacrylate, glycidyl methacrylate, ethyl β-hydroxy acrylate, propyl γ-amino acrylate, stearyl methacrylate, dimethylaminoethyl methacrylate, and diethylaminoethyl methacrylate.

Specifically, the phenoxy resin is a resin formed by the reaction between epihalohydrin and a dihydric phenol compound or a resin formed by the reaction between a dihydric epoxy compound and a dihydric phenol compound.

The phenoxy resin preferably has at least one skeleton selected from the group consisting of a bisphenol A skeleton, a bisphenol F skeleton, a bisphenol A/Fmixed skeleton, a naphthalene skeleton, a fluorene skeleton, a biphenyl skeleton, an anthracene skeleton, a pyrene skeleton, a xanthene skeleton, an adamantane skeleton, and a dicyclopentadiene skeleton. In particular, the phenoxy resin more preferably has at least one skeleton selected from the group consisting of a bisphenol A skeleton, a bisphenol F skeleton, a bisphenol A/F mixed skeleton, a naphthalene skeleton, a fluorene skeleton, and a biphenyl skeleton. The phenoxy resin further preferably has at least one of a fluorene skeleton and a biphenyl skeleton. Use of the phenoxy resin having such preferable skeletons allows the cured product of the insulating sheet to have much higher heat resistance.

The phenoxy resin preferably has a polycyclic aromatic skeleton in the main chain. The phenoxy resin more preferably has at least one of the skeletons represented by the formulas (4) to (9) in the main chain.

[Chem. 4]

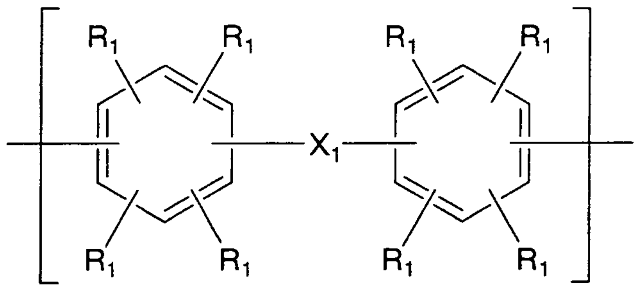

(4)

In the formula (4), $R_1$s each may be the same as or different from each other, and are a hydrogen atom, a C1-C10 hydrocarbon group, or a halogen atom; and $X_1$ is a single bond, a C1-C7 dihydric hydrocarbon group, -O-, -S-, $-SO_2-$, or -CO-.

[Chem. 5]

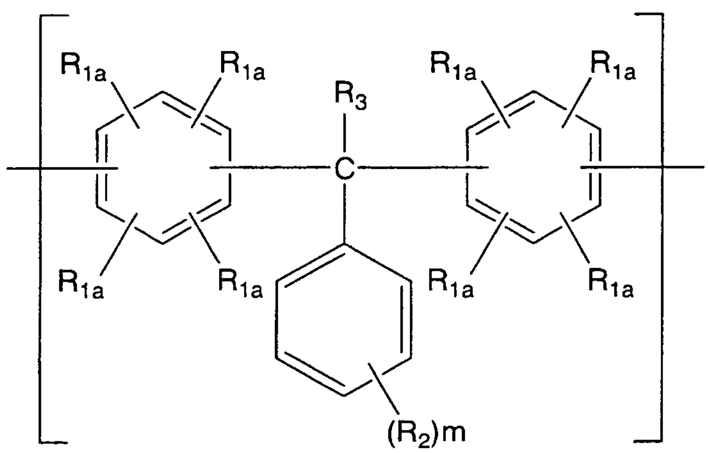

(5)

In the formula (5), $R_{1a}$s each may be the same as or different from each other, and are a hydrogen atom, a C1-C10 hydrocarbon group, or a halogen atom; $R_2$ is a hydrogen atom, a C1-C10 hydrocarbon group, or a halogen atom; $R_3$ is a hydrogen atom or a C1-C10 hydrocarbon group; and m is an integer of 0 to 5.

[Chem. 6]

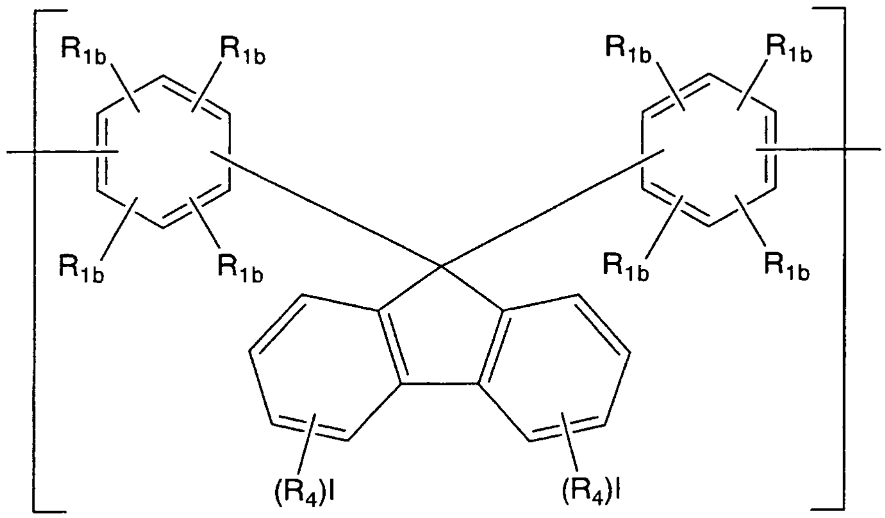

(6)

In the formula (6), $R_{1b}$s each may be the same as or different from each other, and are a hydrogen atom, a C1-C10 hydrocarbon group, or a halogen atom; $R_4$s each may be the same as or different from each other, and are a hydrogen atom, a C1-C10 hydrocarbon group, or a halogen atom; and 1 is an integer of 0 to 4.

[Chem. 7]

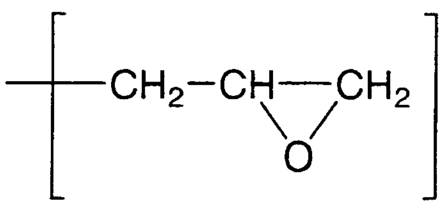

(7)

[Chem. 8]

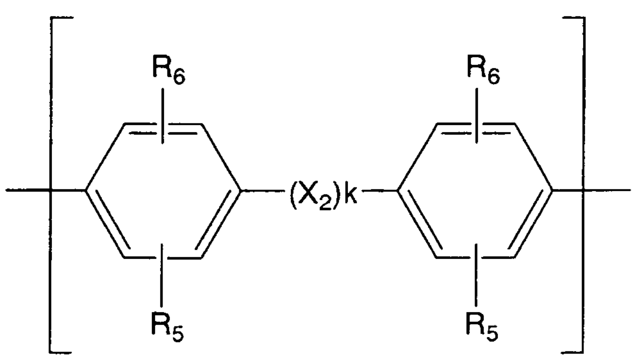

(8)

In the formula (8), $R_5$s and $R_6$s each is a hydrogen atom, a C1-C5 alkyl group, or a halogen atom; $X_2$ is $-SO_2-$, $-CH_2-$, $-C(CH_3)_2-$, or -O-; and k is 0 or 1.

[Chem. 9]

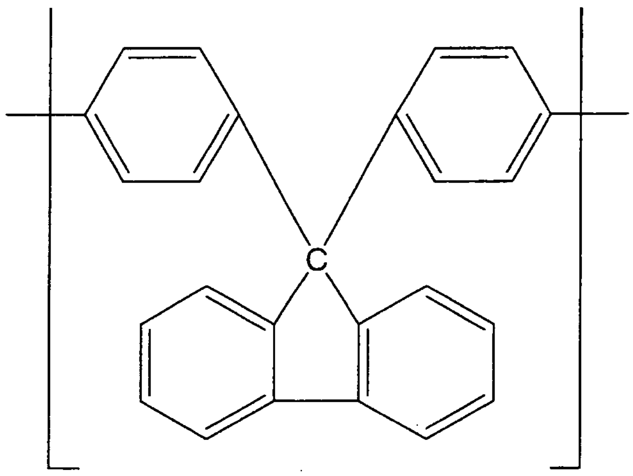

(9)

For example, a phenoxy resin represented by the following formula (10) or (11) may be suitably used as the aforementioned polymer (A).

[Chem. 10]

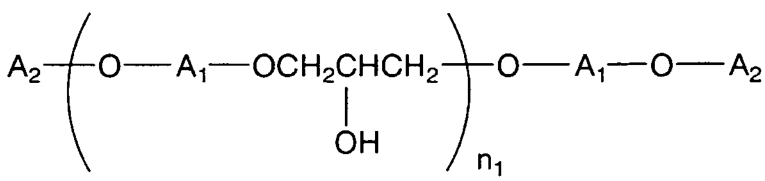

(10)

In the formula (10), $A_1$ has the structures represented by any of the formulas (4) to (6), and the structure of the formula (4) occupies 0 to 60 mol%, the structure of the formula (5) occupies 5 to 95 mol%, and the structure of the formula (6) occupies 5 to 95 mol%; $A_2$ is a hydrogen atom or a group represented by the formula (7); and $n_1$ is 25 to 500 on average.

[Chem. 11]

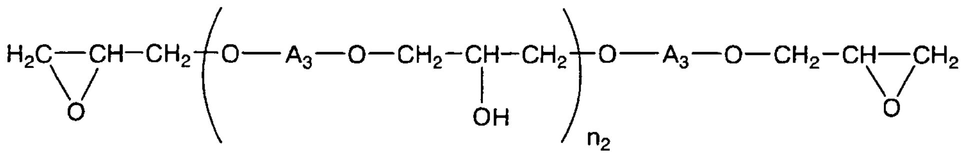 (11)

In the formula (11), $A_3$ has the structure represented by the formula (8) or (9); and $n_2$ is not less than 21.

The polymer (A) has a glass transition temperature Tg of preferably 60˚C to 200˚C, and more preferably 90˚C to 180˚C. A too low Tg of the polymer (A) may cause heat aging of the resin. A too high Tg of the polymer (A) may cause poor compatibility of the polymer (A) with other resins. In these cases, the handleability of the uncured insulating sheet tends to be poor, and the cured product of the insulating sheet tends to have poor heat resistance.

In the case where the polymer (A) is a phenoxy resin, the phenoxy resin has a glass transition temperature Tg of preferably 95˚C or higher, and more preferably 110˚C to 200˚C, and particularly preferably 110˚C to 180˚C. A too low Tg of the phenoxy resin may cause heat aging of the resin. A too high Tg of the phenoxy resin may cause poor compatibility of the phenoxy resin with other resins. In these cases, the handleability of the uncured insulating sheet tends to be poor, and the cured product of the insulating sheet tends to have poor heat resistance.

The polymer (A) preferably has a hydrogen-bonding functional group containing a hydrogen atom. A polymer having a hydrogen-bonding functional group containing a hydrogen atom is highly compatible with a substance (D) or an inorganic filler (G). Accordingly, the dispersibility of the substance (D) or the inorganic filler (G) in the insulating sheet and the adhesion between the polymer (A) and the substance (D) or the inorganic filler (G) are allowed to be improved. Therefore, the cured product of the insulating sheet is allowed to have much higher dielectric breakdown characteristics and thermal conductivity without having a gap in the interface between the resin layer and the substance (D) or the inorganic filler (G).

Examples of the hydrogen-bonding functional group containing a hydrogen atom in the polymer (A) include a hydroxy group (pKa=16), a phosphate group (pKa=7), a carboxyl group (pKa=4), and a sulfonate group (pKa=2).

The hydrogen-bonding functional group containing a hydrogen atom in the polymer (A) is preferably at least one functional group selected from the group consisting of a hydroxy group, a phosphate group, a carboxyl group, and a sulfonate group, more preferably at least one functional group selected from the group consisting of a phosphate group, a carboxyl group, and a sulfonate group. Use of the polymer (A) having such a favorable functional group allows the cured product of the insulating sheet to have much higher dielectric breakdown characteristics and thermal conductivity.

From the standpoint of further improving the dielectric breakdown characteristics and thermal conductivity of the cured product of the insulating sheet, the polymer (A) preferably has a carboxyl group or a phosphate group as a hydrogen-bonding functional group containing a hydrogen atom.

The hydrogen-bonding functional group containing a hydrogen atom preferably has a pKa of 2 to 10, and more preferably 3 to 9. When the pKa is lower than 2, the acidity of the polymer (A) is too high which tends to promote the reaction of the epoxy and the oxetane in the polymer (A). This may result in the insufficient storage stability of the uncured insulating sheet. When the pKa is higher than 10, the dispersibility of the substance (D) or the inorganic filler (G) in the insulating sheet may be not sufficiently improved. This may cause a difficulty in sufficiently improving the dielectric breakdown characteristics and thermal conductivity of the cured product of the insulating sheet.

Examples of the polymer (A) having a hydrogen-bonding functional group containing a hydrogen atom include a polymer having a hydrogen-bonding functional group containing a hydrogen atom such as a carboxylic acid group, a sulfonate group, a phosphate group, and a hydroxy group. Examples of a method for obtaining such a polymer include copolymerization of a monomer having a hydrogen-bonding functional group containing a hydrogen atom with another monomer, graft copolymerization of a stock polymer as a base with a hydrogen-bonding functional group containing a hydrogen atom, and conversion of a derivative of a hydrogen-bonding functional group containing a hydrogen atom in a polymer to a hydrogen-bonding functional group containing a hydrogen atom.

Specific examples of the polymer having a hydrogen-bonding functional group containing a hydrogen atom include a styrenic polymer containing a carboxylic acid group, a phenoxy resin containing a carboxylic acid group, polyester containing a carboxylic acid group, polyether containing a carboxylic acid group, a (meth)acrylic polymer containing a carboxylic acid group, an aliphatic polymer containing a carboxylic acid group, a polysiloxane polymer containing a carboxylic acid group, a styrenic polymer containing a phosphate group, a phenoxy resin containing a phosphate group, polyester containing a phosphate group, polyether containing a phosphate group, an acrylic polymer

containing a phosphate group, an aliphatic polymer containing a phosphate group, a polysiloxane polymer containing a phosphate group, a styrenic polymer containing a sulfonate group, a phenoxy resin containing a sulfonate group, polyester containing a sulfonate group, polyether containing a sulfonate group, a (meth) acrylic polymer containing a sulfonate group, an aliphatic polymer containing a sulfonate group, a polysiloxane polymer containing a sulfonate group, a styrenic polymer containing a hydroxy group, a phenoxy resin containing a hydroxy group, a phenoxy resin containing a hydroxy group, polyester containing a hydroxy group, polyether containing a hydroxy group, a (meth)acrylic polymer containing a hydroxy group, an aliphatic polymer containing a hydroxy group, and a polysiloxane polymer containing a hydroxy group. The polymer (A) having a hydrogen-bonding functional group containing a hydrogen atom may be used alone, or two or more polymers (A) may be used in combination.

The polymer (A) has a weight average molecular weight of 10,000 or more. The weight average molecular weight of the polymer (A) is preferably 30, 000 or more, more preferably in the range of 30,000 to 1,000,000, and further preferably in the range of 40,000 to 250,000. A too low weight average molecular weight of the polymer (A) may cause heat aging of the insulating sheet. A too high weight average molecular weight of the polymer (A) may cause poor compatibility of the polymer (A) with other resins. In these cases, the handleability of the insulating sheet tends to be poor and the cured product of the insulating sheet tends to have poor heat resistance.

The insulating sheet contains 20 to 60% by weight, more preferably 30 to 50% by weight, of the polymer (A) in 100% by weight of all the resin components including the polymer (A), the resin (B), and the curing agent (C) (hereinafter, also referred to as "all the resin components X"). Preferably, the amount of the polymer (A) is in the aforementioned range, and the total amount of the polymer (A) and the resin (B) is less than 100% by weight. A too small amount of the polymer (A) may cause poor handleability of the uncured insulating sheet. A too large amount of the polymer (A) may cause difficulty in dispersing the substance (D). Here, "all the resin components X" include the polymer (A), the epoxy resin (B1), the oxetane resin (B2), the curing agent (C), and the other resin components added if necessary.

(Resin (B))

The insulating sheet according to the present invention contains at least one resin (B) of an epoxy resin (B1) and an oxetane resin (B2). The insulating sheet may contain, as the resin (B), only the epoxy resin (B1), only the oxetane resin (B2), or both of the epoxy resin (B1) and the oxetane resin (82).

The weight average molecular weight of the epoxy resin (B1) is less than 10,000. The weight average molecular weight of the epoxy resin (B1) is not particularly limited as long as it is less than 10,000. As the epoxy resin (B1), an epoxy monomer (B1b) having an aromatic skeleton and a weight average molecular weight of 600 or less is suitably used.

Specific examples of the epoxy resin (B1) include an epoxy monomer having a bisphenol skeleton, an epoxy monomer having a dicyclopentadiene skeleton, an epoxy monomer having a naphthalene skeleton, an epoxy monomer having an adamantane skeleton, an epoxy monomer having a fluorene skeleton, an epoxy monomer having a biphenyl skeleton, an epoxy monomer having a bi(glycidyloxyphenyl)methane skeleton, an epoxy monomer having a xanthene skeleton, an epoxy monomer having an anthracene skeleton, and an epoxy monomer having a pyrene skeleton. Each of these epoxy resins (B1) may be used alone, or two or more of these may be used in combination.

Examples of the epoxy monomer having a bisphenol skeleton include an epoxy monomer having a bisphenol A skeleton, a bisphenol F skeleton, or a bisphenol S skeleton.

Examples of the epoxy monomer having a dicyclopentadiene skeleton include a phenol novolac epoxy monomer having a dicyclopentadiene dioxide skeleton or a dicyclopentadiene skeleton.

Examples of the epoxy monomer having a naphthalene monomer include 1-glycidyl naphthalene, 2-glycidyl naphthalene, 1,2-diglycidyl naphthalene, 1,5-diglycidyl naphthalene, 1, 6-diglycidyl naphthalene, 1,7-diglycidyl naphthalene, 2,7-diglycidyl naphthalene, triglycidyl naphthalene, and 1,2,5,6-tetraglycidyl naphthalene.

Examples of the epoxy monomer having an adamantane skeleton include 1,3-bis(4-glycidyloxyphenyl)adamantane and 2,2-bis(4-glycidyloxyphenyl)adamantane.

Examples of the epoxy monomer having a fluorene skeleton include 9,9-bis(4-glycidyloxyphenyl)fluorene, 9,9-bis(4-glycidyloxy-3-methylphenyl)fluorene, 9,9-bis(4-glycidyloxy-3-chlorophenyl)fluorene, 9,9-bis(4-glycidyloxy-3-bromophenyl)fluorene, 9,9-bis(4-glycidyloxy-3-fluorophenyl)fluorene, 9,9-bis(4-glycidyloxy-3-methoxyphenyl)fluorene, 9,9-bis(4-glycidyloxy-3,5-dimethylphenyl)fluorene, 9,9-bis(4-glycidyloxy-3,5-dichlorophenyl)fluorene, and 9,9-bis(4-glycidyloxy-3,5-dibromophenyl)fluorene.

Examples of the epoxy monomer having a biphenyl skeleton include 4,4'-diglycidylbiphenyl and 4,4'-diglycidyl-3,3',5,5'-tetramethylbiphenyl.

Examples of the epoxy monomer having a bi(glycidyloxyphenyl)methane skeleton include 1,1'-bi(2,7-glycidyloxynaphthyl)methane, 1,8'-bi(2,7-glycidyloxynaphthyl)methane, 1,1'-bi(3,7-glycidyloxynaphthyl)methane, 1,8'-bi(3,7-glycidyloxynaphthyl)methane, 1,1'-bi(3,5-glycidyloxynaphthyl)methane, 1,8'-bi(3,5-glycidyloxynaphthyl)methane, 1,2'-bi(2,7-glycidyloxynaphthyl)methane, 1,2'-bi(3,7-glycidyloxynaphthyl)methane, and 1,2'-bi(3,5-glycidyloxynaphthyl) methane.

Examples of the epoxy monomer having a xanthene skeleton include 1,3,4,5,6,8-hexamethyl-2,7-bis-oxiranylmethoxy-9-phenyl-9H-xanthene.

The oxetane resin (B2) has a weight average molecular weight of less than 10,000. The oxetane resin (B2) is not particularly limited as long as it has a weight average molecular weight of less than 10, 000. As the oxetane resin (B2), an oxetane monomer (B2b) having an aromatic skeleton and a weight average molecular weight of 600 or less is favorably used.

Specific examples of the oxetane resin (B2) include 4,4'-bis[(3-ethyl-3-oxetanyl)methoxymethyl]biphenyl, 1,4-benzenedicarboxylic acid bis[(3-ethyl-3-oxetanyl)methyl]ester, 1,4-bis[(3-ethyl-3-oxetanyl)methoxymethyl]benzene, and oxetane-modified phenol novolac. Each of these oxetane resins (B2) may be used alone, or two or more of these may be used in combination.

The resin (B) preferably has a hydroxy group equivalent of 6000 or more. In this case, the uncured insulating sheet is allowed to have further improved handleability. The hydroxy group equivalent of the resin (B) is more preferably 6,500 or more, further preferably 7,000 or more, and most preferably 15,000 or more.

The hydroxy group equivalent of the resin (B) is obtained by determining the amount (W mol%) of the hydroxy group with respect to the entire resin (B) with use of a high-speed liquid chromatography-mass spectrometry (LC-MS) or a $^{1}$H-nuclear magnetic resonance spectroscopy ($^{1}$H-NMR) and assigning the obtained value to the following equation.

$$\text{The hydroxy group equivalent} = (\text{Weight average molecular weight}/W) \times 100$$

The resin (B) preferably has a theoretical chemical structure purity of 90% or higher, more preferably 95% or higher, and further preferably 97% or higher. The higher the theoretical chemical structure purity of the resin (B) is, the higher the handleability of the uncured insulating sheet becomes.

The "theoretical chemical structure purity of the resin (B)" refers to the percentage of a substance having a three-membered (epoxy) or four-membered (oxetane) cyclic ether structure and having no hydroxy group.

The resin (B) is preferably at least one of a distilled epoxy resin and a distilled oxetane resin, and more preferably the distilled epoxy resin. In this case, the uncured insulating sheet is allowed to have much higher handleability.

The weight average molecular weight of the epoxy resin (B1) and the oxetane resin (B2), that is , the weight average molecular weight of the resin (B), is less than 10, 000. The weight average molecular weight of the resin (B) is preferably 600 or less. The preferable lower limit of the weight average molecular weight of the resin (B) is 200, and the more preferable upper limit thereof is 550. The resin (B) having a too low weight average molecular weight may cause too high volatility of the resin (B), resulting in poor handleability of the insulating sheet. The resin (B) having a too high weight average molecular weight may make the insulating sheet hard and brittle, resulting in poor adhesion of the cured product of the insulating sheet.

The insulating sheet preferably contains 10 to 60% by weight, more preferably 10 to 40% by weight of the resin (B) in 100% by weight of all the resin components X. The amount of the resin (B) is preferably in the above range while the total amount of the polymer (A) and the resin (B) is less than 100% by weight. A too small amount of the resin (B) tends to cause the cured product of the insulating sheet to have poor adhesion and heat resistance. A too large amount of the resin (B) tends to cause the insulating sheet to have poor flexibility.

The resin (B) preferably contains at least one of an epoxy monomer (B1b) having an aromatic skeleton and a weight average molecular weight of 600 or less and an oxetane monomer (B2b) having an aromatic skeleton and a weight average molecular weight of 600 or less.

The resin (B) contains preferably 40 to 100% by weight, more preferably 60 to 100% by weight, and particularly preferably 80 to 100% by weight of at least one of the epoxy monomer (B1b) having an aromatic skeleton and a weight average molecular weight of 600 or less and the oxetane monomer (B2b) having an aromatic skeleton and a weight average molecular weight of 600 or less. The amount of the epoxy monomer (B1b) and the oxetane monomer (B2b) in the above preferable range allows the insulating sheet to have much higher flexibility and the cured product of the insulating sheet to have much higher adhesion and thermal resistance.

(Curing agent (C))

The curing agent (C) contained in the insulating sheet according to the present invention is not particularly limited. The curing agent (C) is preferably a phenol resin, an acid anhydride having an aromatic skeleton or an alicyclic skeleton, a hydrogenated product of the acid anhydride, or a modified product of the acid anhydride. This preferable

curing agent (C) provides the cured product of the insulating sheet having an excellent balance among heat resistance, moisture resistance, and electric properties. The curing agent (C) may be used alone, or two or more of the curing agents (C) may be used in combination.

The phenol resin is not particularly limited. Specific examples of the phenol resin include phenol novolac, o-cresol novolac, p-cresol novolac, t-butyl phenol novolac, dicyclopentadiene cresol, polyparavinyl phenol, bisphenol A novolac, xylylene-modified novolac, decalin-modified novolac, poly(di-o-hydroxyphenyl)methane, poly(di-m-hydroxyphenyl)methane, and poly(di-p-hydroxyphenyl)methane. In particular, a phenol resin having a melamine skeleton, a phenol resin having a triazine skeleton, or a phenol resin having an allyl group is preferable as these phenol resins allow the insulating sheet to have much higher flexibility and flame retardancy.

Commercially available products of the phenol resin include MEH-8005, MEH-8010, and NEH-8015 (produced by Meiwa Plastic Industries, Ltd.); YLH903 (produced by Japan Epoxy Resins Co., Ltd.); LA-7052, LA-7054, LA-7751, LA-1356, and LA-3018-50P (produced by Dainippon Ink and Chemicals, Corp.); and PS6313 and PS6492 (produced by Gunei Chemical Industry Co., Ltd.).

The acid anhydride having an aromatic skeleton, the hydrogenated product of the acid anhydride, or the modified product of the acid anhydride is not particularly limited. Examples of the acid anhydride having an aromatic skeleton, the hydrogenated product of the acid anhydride, or the modified product of the acid anhydride include copolymers of styrene and maleic anhydride, benzophenone tetracarboxylic anhydrides, pyromellitic anhydride, trimellitic anhydride, 4,4'-oxydiphthalic anhydride, phenylethynylphthalic anhydride, glycerol bis(anhydrotrimellitate)monoacetate, ethyleneglycol bis(anhydrotrimellitate), methyltetrahydrophthalic anhydride, methylhexahydrophthalic anhydride, and trialkyltetrahydrophthalic anhydrides. In particular, a methyl nadic anhydride or a trialkyltetrahydrophthalic anhydride is preferable. The methyl nadic anhydride and the trialkyltetrahydrophthalic anhydride allow the cured product of the insulating sheet to have higher water resistance.

Commercially available products of the acid anhydride having an aromatic skeleton, the hydrogenated product of the acid anhydride, or the modified product of the acid anhydride include SMA resin EF30, SMA resin EF40, SMA resin EF60, and SMA resin EF80 (produced by Sartomer Japan Inc.); ODPA-M and PEPA (produced by MANAC Inc.); RIKACID MTA-10, RIKACID MTA-15, RIKACID TMTA, RIKACID TMEG-100, RIKACID TMEG-200, RIKACID TMEG-300, RIKACID TMEG-500, RIKACID TMEG-S, RIKACID TH, RIKACID HT-1A, RIKACID HH, RIKACID MH-700, RIKACID MT-500, RIKACID DSDA, and RIKACID TDA-100 (produced by New Japan Chemical Co., Ltd.); and EPICLON B4400, EPICLON B650, and EPICLON B570 (produced by Dainippon Ink and Chemicals, Corp.).

Further, the acid anhydride having an alicyclic skeleton, the hydrogenated product of the acid anhydride, or the modified product of the acid anhydride is preferably a first acid anhydride having a polyalicyclic skeleton, a hydrogenated product of the first acid anhydride, or a modified product of the first acid anhydride, or a second acid anhydride formed by addition reaction of a terpene compound and maleic anhydride, a hydrogenated product of the second acid anhydride, or a modified product of the second acid anhydride. In this case, the insulating sheet is allowed to have much higher flexibility, moisture resistance, or adhesion. In addition, the acid anhydride having an alicyclic skeleton, the hydrogenated product of the acid anhydride, or the modified product of the acid anhydride may be a methyl nadic anhydride, an acid anhydride having a dicyclopentadiene skeleton, or a modified product of either of the acid anhydrides.

Commercially available products of the first acid anhydride having an alicyclic skeleton, the hydrogenated product of the first acid anhydride, or the modified product of the first acid anhydride include RIKACID HNA and RIKACID HNA-100 (produced by New Japan Chemical Co., Ltd.); and EPIKURE YH306, EPIKURE YH307, EPIKURE YH308H, and EPIKURE YH309 (produced by Japan Epoxy Resins Co., Ltd.).

The curing agent (C) is preferably an acid anhydride represented by any one of the following formulas (1) to (3). This preferable curing agent (C) allows the insulating sheet to have much higher flexibility, moisture resistance, or adhesion.

[Chem. 1]

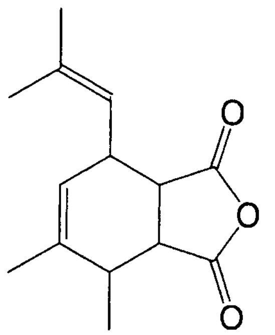

(1)

[Chem. 2]

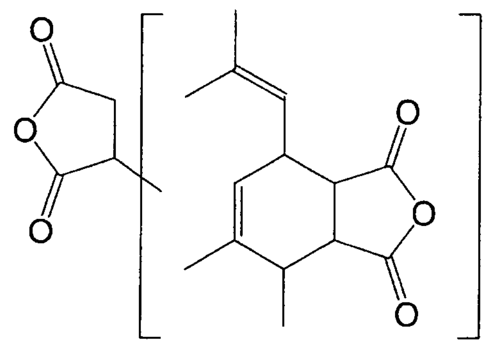

(2)

[Chem. 3]

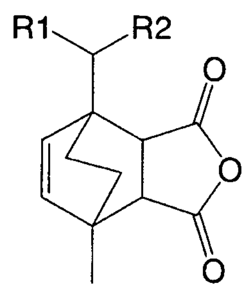

(3)

In the formula (3), R1 and R2 each are hydrogen, a C1-C5 alkyl group, or a hydroxy group.

In addition to the curing agent, a curing accelerator may be contained in the insulating sheet for adjusting a curing rate and physical properties of the cured product.

The curing accelerator is not particularly limited. Specific examples of the curing accelerator include tertiary amines, imidazoles, imidazolines, triazines, organophosphorus compounds, and diazabicycloalkenes such as quaternary phosphonium salts and organic acid salts. Examples of the curing accelerator further include organic metal compounds, quaternary ammonium salts, and halogenated metals. Examples of the organic metal compound include zinc octylate,

tin octylate, and aluminum-acetyl-acetone complexes.

Examples of the curing accelerator include imidazole curing accelerators with a high melting point, dispersible latent curing accelerators with a high melting point, micro-capsulated latent curing accelerators, amine salt latent curing accelerators, and high-temperature dissociative and thermal cation polymerizable latent curing accelerators. Each of these curing accelerators may be used alone, or two or more of these may be used in combination.

Examples of the dispersible latent accelerator with a high melting point include amine-addition accelerators in which dicyanamide or amine is added to an epoxy monomer. Examples of the micro-capsulated latent accelerator include micro-capsulated latent accelerators formed by covering the surface of an accelerator such as an imidazole accelerator, a phosphorus accelerator, or a phosphine accelerator with a polymer. Examples of the high-temperature dissociative and thermal cation polymerizable latent curing accelerator include Lewis acid salts and Bronsted acid salts.

The curing accelerator is preferably an imidazole curing accelerator with a high melting point. The imidazole curing accelerator with a high melting point enables easy control of the reaction system and much easier adjustment of the curing rate of the insulating sheet and the physical properties of the cured product of the insulating sheet. A curing accelerator with a high melting point of 100˚C or higher may be excellently easy to handle. Thus, the curing accelerator preferably has a melting point of 100˚C or higher.

The insulating sheet contains preferably 10 to 40% by weight, and more preferably 12 to 25% by weight, of the curing agent (C) in 100% by weight of all the resin components X. A too small amount of the curing agent (C) may cause difficulty in sufficiently curing the insulating sheet. A too large amount of the curing agent (C) may cause an excessive amount of the curing agent which is not involved in the curing or may cause insufficient cross-linking of the cured product. This may cause the cured product of the insulating sheet to have insufficient heat resistance and adhesion.

(Substance (D))

The insulating sheet according to the present invention comprises a substance (D) of at least one of magnesium carbonate anhydrous (D1) represented by $MgCO_3$ and containing no crystal water and a coated body (D2) obtainable by coating the surface of the magnesium carbonate anhydrous (D1) with an organic resin, a silicone resin, or silica. As the substance (D), either one of the magnesium carbonate anhydrous (D1) or the coated body (D2) may be used, or both of he magnesium carbonate anhydrous (D1) and the coated body (D2) may be used in combination.

Use of the substance (D) as a filler allows the cured product of the insulating sheet to have higher processability while maintaining sufficient thermal conductivity and heat resistance. Since the insulating sheet according to the present invention is excellent in the processability, the abrasion of the equipment used for processing the insulating sheet is reduced. This allows stable production of the insulating sheet for a long time.

Commonly used fillers to provide thermal conductivity include aluminum nitride, boron nitride, alumina, magnesium oxide, and silica. A nitride has very high thermal conductivity. For example, aluminum nitride has thermal conductivity of 150 to 250 W/m·K and boron nitride has thermal conductivity of 30 to 50 W/m·K. However, nitrides are very expensive. Alumina is comparatively inexpensive and has comparatively high thermal conductivity of 20 to 35 W/m·K. However, alumina has a high hardness of 9 in Mohs' hardness. Therefore, use of alumina may cause a problem of abrasion of the equipment used for processing. Magnesium oxide is inexpensive and has fine thermal conductivity of 45 to 60 W/m·K. However, magnesium oxide has poor water resistance and has a high hardness of 6 in Mohs' hardness. Therefore, use of magnesium oxide may cause a problem in processability. Though silica is quite inexpensive, silica has low thermal conductivity of 2 W/m·K and high hardness of 6 in Mohs' hardness.

The magnesium carbonate anhydrous (D1) represented by $MgCO_3$ and containing no crystal water has comparatively good thermal conductivity of 15 W/m·K and low hardness of 3. 5 in Mohs' hardness. In addition, the magnesium carbonate anhydrous (D1) is inexpensive compared to nitrides. Accordingly, use of the magnesium carbonate anhydrous (D1) or the coated body (D2) containing the magnesium carbonate anhydrous can reduce the production cost of the insulating sheet.

The magnesium carbonate anhydrous (D1) represented by $MgCO_3$ and containing no crystal water is different from, for example, magnesium hydroxy carbonate represented by $4MgCO_3 \cdot Mg(OH_2) \cdot 4H_2O$. The magnesium hydroxy carbonate may be simply referred to as magnesium carbonate. The magnesium hydroxy carbonate heated to around 100˚C discharges crystal water. Therefore, the magnesium hydroxy carbonate is not suitably used in an application which requires, for example, high solder dip resistance.

Natural products and synthetic products are provided as the magnesium carbonate anhydrous (D1) represented by $MgCO_3$ and containing no crystal water. Use of a natural product containing impurities may provide unstable physical properties such as heat resistance. Accordingly, a synthetic magnesium carbonate anhydrous (D1) is preferably used.

The coated body (D2) has a core-shell structure comprising the magnesium carbonate anhydrous (D1) as a core and a coat layer made of a silicone resin or silica as a shell. The coat layer allows the coated body (D2) to have high dispersibility in a resin. In addition, use of the coated body (D2) comprising the coat layer allows the cured product of the insulating sheet to have much higher acid resistance.

A method of coating the surface of the magnesium carbonate anhydrous (D1) with the coat layer is not particularly limited. For example, the magnesium carbonate anhydrous (D1) is dispersed in a solution containing an organic resin, a silicone resin, or a silane coupling agent as a silica material and the obtained dispersion liquid may be spray dried. For another example, the magnesium carbonate anhydrous (D1) is dispersed in a solution containing an organic resin or a silicone resin, and a poor solvent of an organic resin or of a silicone resin is added thereto so as to separate the organic resin or polysiloxane out on the surface of the magnesium carbonate anhydrous (D1). For still another example, an acrylic resin, a styrenic resin, or a polymerizable monomer such as low molecular weight silane is reacted in a medium in which the magnesium carbonate anhydrous (D1) is dispersed, and an organic resin, a silicone resin, or silica which becomes to have a too high molecular weight to be dissolved in the medium are separated out on the surface of the magnesium carbonate anhydrous (D1).

The organic resin is not particularly limited as long as it can coat the surface of the magnesium carbonate anhydrous (D1). The organic resin is preferably capable of providing the cured product with acid resistance. The organic resin may be a thermosetting resin or a thermoplastic resin.

Specific examples of the organic resin include (meth)acrylic resins, styrenic resins, urea resins, melamine resins, phenol resins, thermoplastic urethane resins, thermosetting urethane resins, epoxy resins, thermoplastic polyimide resins, thermosetting polyimide resins, amino alkyd resins, phenoxy resins, phthalate resins, polyamide resins, ketone resins, norbornene resins, polyphenylene sulfide, polyarylate, polysulfone, polyethersulfone, polyetheretherketone, polyetherketone, thermoplastic polyimide, thermosetting polyimide, benzoxazine, and a reaction product of polybenzoxazole with benzoxazine. In particular, a (meth)acrylic resin or a styrenic resin is preferably used because it has a wide variety of monomers so as to allow formation of various coat layers and the reaction is easily controlled by heat or light.

The styrenic resins are not particularly limited. Examples thereof include styrene, o-methylstyrene, m-methylstyrene, p-methylstyrene, p-methoxystyrene, p-phenylstyrene, p-chlorostyrene, p-ethylstyrene, p-n-butylstyrene, p-tert-butylstyrene, p-n-hexylstyrene, p-n-octylstyrene, p-n-nonylstyrene, p-n-decylstyrene, p-n-dodecylstyrene, 2,4-dimethylstyrene, 3,4-dichlorostyrene, and divinyl benzene.

Examples of the (meth) acrylic resins include alkyl (meth)acrylate, (meth)acrylonitrile, (meth)acrylamide, (meth) acrylic acid, glycidyl (meth)acrylate, 2-hydroxyethyl (meth)acrylate, 2-hydroxypropyl (meth)acrylate, ethylene glycol di (meth)acrylate, trimethylolpropane (meth)acrylate, and dipentaerythritol (meth)acrylate. Examples of the alkyl (meth) acrylate include methyl (meth)acrylate, ethyl (meth)acrylate, propyl (meth)acrylate, butyl (meth)acrylate, cumyl (meth) acrylate, cyclohexyl (meth)acrylate, myristyl (meth)acrylate, palmityl (meth)acrylate, stearyl (meth)acrylate, and isobornyl (meth)acrylate.

The organic resin preferably contains a cross-linking monomer having two or more reactive groups in the molecule because the insulating sheet is allowed to have higher acid resistance during etching.

The organic resin for forming the coat layer preferably has a SP value according to the Okitsu method of 10 $(cal/cm^3)^{1/2}$ or less because infiltration of the etchant into the coat layer formed by the organic resin can be avoided.

The Okitsu method is specifically described by the following formula (X).

$$\delta = (\Sigma\Delta F)/(\Sigma\Delta v) \quad \ldots (X)$$

In the formula (X), $\delta$ is a SP' value ($(cal/cm^3)^{1/2}$), $\Delta F$ is the molar attraction constant of each atom group, and $\Delta v$ is the molar volume of each atom group.

The Okitsu method is described in "Adhesion", vol. 40, No. 8, pp. 342-350 (1996).

The coat layer preferably has a thickness of 10 nm to 1 μm. The coat layer having a thickness of less than 10 nm may fail to sufficiently improve the dispersibility of the coated body (D2) in the resin and the acid resistance of the cured product of the insulating sheet. The coat layer having a thickness of more than 1 μm may significantly lower the thermal conductivity of the coated body (D2).

The shape of the substance (D) is not particularly limited. The substance (D) preferably has a substantially polyhedral shape or a shape having an aspect ratio of 1 to 2. Here, the aspect ratio is a ratio between the length and the breadth. In this case, the substance (D) can be filled into the insulating sheet at a high density to improve the heat dissipation of the cured product of the insulating sheet.

The substance (D) is preferably at least one substance (Dd1) of spherical magnesium carbonate anhydrous (D1d1) represented by $MgCO_3$ and containing no crystal water and a coated body (D2d1) obtainable by coating the surface of the spherical magnesium carbonate anhydrous (D1d1) with an organic resin, a silicone resin, or silica. The coated body (D2d1) in a spherical shape is obtained by coating the surface of the spherical magnesium carbonate anhydrous (D1d1) with an organic resin, a silicone resin, or silica. The substance (Dd1) preferably has a spherical shape.

In such a case, it is possible to fill the substance (Dd1) into the insulating sheet at a high density to allow the cured product of the insulating sheet to have high heat dissipation capability. In addition, the cured product of the insulating sheet is allowed to have higher dielectric breakdown characteristics.

It is to be noted that the spherical shape is not limited to a perfect sphere and include a slightly-compressed sphere and a slightly-distorted sphere. Examples thereof include a shape having an aspect ratio of 1 to 1.5, and a shape with the surface mostly (e.g. 30% or more) comprising the curved face and partially (e.g. less than 70%) comprising the flat shape. In the latter example, more preferably 50% or more, and further preferably 70% or more, of the surface is a curved face.

The spherical magnesium carbonate anhydrous (D1d1), the coated body (D2d1) prepared with use of the spherical magnesium carbonate anhydrous, or the spherical substance (Dd1) is preferably prepared by spheroidization with use of a grinding machine having a jet mill or a rotating rotor and a stator. Such spherodization can improve the sphericity to allow the shape to be a perfect sphere or an almost perfect sphere. In addition, the agglomerate of the substance (D) can be crushed in the spherodization. This allows the cured product of the insulating sheet to have much higher heat dissipation capability. Further, the cured product of the insulating sheet is allowed to have much higher dielectric breakdown characteristics.

The substance (D) preferably has the average particle size of 0.1 to 40 μm. The average particle size of less than 0.1 μm may make it difficult to fill the substance (D) into the insulating sheet at a high density. The average particle size of more than 40 μm may lower the dielectric breakdown characteristics of the cured product of the insulating sheet in the case of making the insulating sheet having a thickness of about 100 μm thin.

Here, "the average particle size" is obtained from the volume-weighted particle size distribution measured with use of a laser diffraction particle size analyzer.

In order to form a close-packed structure in the insulating sheet to improve the heat dissipation capability of the cured product of the insulating sheet, two or more substances (D) different in shape or particle size may be used in combination.

The substance (D) is also preferably at least one substance (Dd2) of substantially-polyhedral magnesium carbonate anhydrous (D1d2) represented by $MgCO_3$ and containing no crystal water and a coated body (D2d2) obtainable by coating the surface of the substantially-polyhedral magnesium carbonate anhydrous (D1d2) with an organic resin, a silicone resin, or silica. The coated body (D2d2) in a substantially-polyhedral shape is obtained by coating the surface of the substantially-polyhedral magnesium carbonate anhydrous (D1d2) with an organic resin, a silicone resin, or silica. The substance (Dd2) preferably has a spherical shape. In the case where the substance (Dd2) has a substantially-polyhedral shape, it is preferable that the insulating sheet further comprises an inorganic filler (G) other than the substance (D) and that the inorganic filler (G) and the inorganic filler (G) is a plate filler.

In the case where the substance (Dd2) has a substantially-polyhedral shape and the plate filler is contained in the insulating sheet, the substance (Dd2) and the plate filler are not in point contact but in surface contact with each other so that the contact area thereof becomes larger. In addition, contact or approach of a plurality of substances (Dd2) dispersed separately in the insulating sheet through the plate filler allows the insulating sheet to have a structure in which respective fillers are crosslinked or efficiently approached to each other. This allows the cured product of the insulating sheet to have much higher thermal conductivity.

Here, "substantially-polyhedral shape" includes not only a polyhedral shape comprising only flat faces which follows the common definition of a polyhedral shape, but also a shape comprising curved faces up to a predetermined percentage in addition to flat faces. For example, the substantially-polyhedral shape may be a shape with the surface comprising 10% or less of curved faces and 90% or more of flat faces. The substantially-polyhedral shape is preferably a substantial-cube or a substantial-cuboid.

The amount of the substance (D) is preferably 20 to 90% by volume in 100% by volume of the insulating sheet. The lower limit thereof is more preferably 30% by volume and the upper limit thereof is more preferably 80% by volume. A too small amount of the substance (D) may fail to sufficiently improve the heat dissipation capability of the cured product of the insulating sheet. The amount of the substance (D) exceeding 90% may significantly lower the flexibility and adhesion of the insulating sheet.

In the case where the inorganic filler(G) is not contained in the insulating sheet, the amount of the substance (D) is more preferably 30 to 90% by volume in 100% by volume of the insulating sheet.

(Inorganic filler (G))

The insulating sheet according to the present invention preferably contains an inorganic filler other than the substance (D). Containing the inorganic filler (G), the insulating sheet can have high processability and provide a curable product having much higher thermal conductivity. The inorganic filler (G) used may be one filler or may be a combination of two or more fillers.

The above inorganic filler (G) is not particularly limited, and is preferably at least one substance selected from

the group consisting of alumina, silica, boron nitride, aluminum nitride, silicon nitride, silicon carbide, zinc oxide, magnesium oxide, talc, mica, and hydrotalcite. In this case, the heat dissipation capability of the cured product of the insulating sheet can be further improved.

The inorganic filler (G) is particularly preferably spherical. The inorganic filler (G) may be filled into the insulating sheet at a high density when it has a spherical shape, so that the cured product of the insulating sheet is allowed to have much higher heat dissipation capability.

The inorganic filler (G) preferably has an average particle size in the range of 0.1 to 40 μm. An average particle size of smaller than 0.1 μm may cause difficulty in filling the inorganic filler (G) into the insulating sheet at a high density. An average particle size exceeding 40 μm may cause the cured product of the insulating sheet to have poor dielectric breakdown characteristics.

The term "average particle size" herein represents an average particle size determined from the result of particle size distribution measurement in terms of volume average measured with a laser diffractive particle size distribution measuring apparatus.

In the case of containing the above substance (Dd2), the inorganic filler is preferably a plate filler.

The above substance (Dd2) has an average particle size preferably in the range of 0.1 to 40 μm, and the plate filler has an average length preferably in the range of 1 to 10 μm. The substance (Dd2) having such a shape and a plate filler can come into contact with each other sufficiently in the insulating sheet. For this reason, the cured product of the insulating sheet can have much higher thermal conductivity.

An average length of the plate filler of less than 0.1 μm may make it difficult for the plate filler to be filled into the insulating sheet, or to sufficiently cross link the substantially-polyhedral substances (Dd2) in an efficient manner. An average length of the plate filler exceeding 10 μm may easily deteriorate the insulating property of the insulating sheet. The plate filler has an average length more preferably in the range of 0.5 to 9 μm, and further preferably in the range of 1 to 9 μm.

The plate filler preferably has an average thickness of 100 nm or more. If the plate filler has an average thickness of 100 nm or more, the cured product can have much higher thermal conductivity. The plate filler has an aspect ratio preferably in the range of 2 to 50. An aspect ratio of the plate filler exceeding 50 may make it difficult for the plate filler to be filled into the insulating sheet. The plate filler has an aspect ratio more preferably in the range of 3 to 45.

The plate filler is preferably at least one of alumina and boron nitride. The insulating sheet can have much higher thermal conductivity when the plate filler is at least one of alumina and boron nitride. Particularly when the substance (Dd2) and at least one of alumina and boron nitride are used in combination, the cured product of the insulating sheet can have much higher thermal conductivity.

In the case that the substance (D) and the inorganic filler (G) are used together, the optimum amounts of those components are appropriately determined according to the respective kinds, particle sizes, and shapes of the substance (D) and the inorganic filler (G). The total amount of the substance (D) and the inorganic filler (G) in 100% by volume of the insulating sheet is preferably in the range of 60 to 90% by volume. A total amount of the substance (D) and the inorganic filler (G) of less than 60% by volume may not sufficiently increase the heat dissipation capability of the cured product. A total amount of the substance (D) and the inorganic filler (G) exceeding 90% by volume may significantly decrease the flexibility or adhesion of the insulating sheet.

In the case that the substance (D) and the inorganic filler (G) are used together, the amount of the substance (D) in 100% by volume of the insulating sheet is preferably in the range of 20 to 80% by volume.

The insulating sheet preferably contains the substance (Dd2) and the plate filler at a volume ratio of 70:30 to 99:1. The total amount of the substance (Dd2) and the plate filler contained in 100% by volume of the insulating sheet is preferably 60 to 90% by volume. It is more preferable that the insulating sheet contain the substance (Dd2) and the plate filler at a volume ratio of 70:30 to 99:1 and, the total amount of the substance (Dd2) and the plate filler contained in 100% by volume of the insulating sheet be 60 to 90% by volume. In the case that the amounts of the substance (D2d) and the plate filler are in the respective preferable ranges, the cured product of the insulating sheet can have much higher processability and thermal conductivity.

(Dispersant (F))

The insulating sheet according to the present invention preferably contains a dispersant (F). The dispersant (F) preferably has a hydrogen-bonding functional group containing a hydrogen atom. Containing the dispersant (F), the insulating sheet can provide a cured product having much higher thermal conductivity and dielectric breakdown characteristics.

Examples of the hydrogen-bonding functional group containing a hydrogen atom include a carboxyl group (pKa = 4), a phosphoric acid group (pKa = 7), and a phenol group (pKa = 10).

The hydrogen-bonding functional group containing a hydrogen atom in the dispersant (F) has a pKa of preferably 2 to 10, and more preferably 3 to 9. If the pKa is lower than 2, the dispersant (F) has a too high acidity, so that reactions

of the epoxy resin and the oxetane resin in the resin component are likely to be accelerated. Accordingly, in the case that the uncured insulating sheet is stored, the uncured insulating sheet may have poor storage stability. If the pKa of the functional group is higher than 10, the dispersant (F) may insufficiently exert its effects, and the cured product of the insulating sheet may have insufficient thermal conductivity and dielectric breakdown characteristics.

The hydrogen-bonding functional group containing a hydrogen atom is preferably a carboxyl group or a phosphoric acid group. In this case, the cured product of the insulating sheet is allowed to have much higher thermal conductivity and dielectric breakdown characteristics.

Specific examples of the dispersant (F) include polyester carboxylic acids, polyether carboxylic acids, polyacrylic carboxylic acids, aliphatic carboxylic acids, polysiloxane carboxylic acids, polyester phosphoric acids, polyether phosphoric acids, polyacrylic phosphoric acids, aliphatic phosphoric acids, polysiloxane phosphoric acids, polyester phenols, polyether phenols, polyacrylic phenols, aliphatic phenols, and polysiloxane phenols. The dispersant (F) may be a single dispersant or a combination of two or more dispersants.

The insulating sheet contains preferably 0.01 to 20% by weight, and more preferably 0.1 to 10% by weight, of the dispersant (F) in 100% by weight of the insulating sheet. The dispersant (F) in an amount within this range may prevent agglomeration of the filler (D) and allow the cured product of the insulating sheet to have much higher thermal conductivity and dielectric breakdown characteristics.

(Granular rubber (E))

The insulating sheet according to the present invention may contain granular rubber (E).

The granular rubber (E) is not particularly limited. Examples of the granular rubber (E) include acryl rubber, butadiene rubber, isoprene rubber, acrylonitrile-butadiene rubber, styrene-butadiene rubber, styrene-isoprene rubber, urethane rubber, silicone rubber, fluorine rubber, and natural rubber. In the case of containing the granular rubber, the cured product of the insulating sheet is allowed to have a higher stress relaxation property and a higher flexibility, and is restrained from having a decreased heat resistance. The granular rubber may have any property.

Combination use of the granular rubber (E) and the substance (D) allows the cured product of the insulating sheet to have a low coefficient of linear thermal expansion and to express stress relaxation capability. Thus, the cured product of the insulating sheet is less likely to suffer peeling or cracking even under high temperature conditions or temperature cycle conditions.

The insulating sheet contains preferably 0.1 to 40% by weight, and more preferably 0.3 to 20% by weight, of the granular rubber (E) in 100% by weight of the insulating sheet. A too small amount of the granular rubber (E) may cause the cured product of the insulating sheet to have an insufficient stress relaxation property. A too large amount of the granular rubber (E) may cause the cured product of the insulating sheet to have poor adhesion.

(Other components)

The insulating sheet according to the present invention may contain a substrate material such as glass cloth, nonwoven glass fabric, or nonwoven aramid fabric for much better handleability. Here, the insulating sheet according to the present invention has self supportability without containing the substrate material even when it is uncured at room temperature (23˚C), and the handleability thereof is excellent. Thus, the insulating sheet is preferably free from a substrate material, in particular, glass cloth. When being free from the substrate material, the insulating sheet may be made thin, and the cured product of the insulating sheet may have much higher thermal conductivity. Further, the insulating sheet may be easily subjected to processes such as laser processing and drilling if necessary. Here, the term "self supportability" means that the sheet is capable of retaining its shape and being handled as a sheet even without a supporting medium such as a PET film or a copper foil and even when it is uncured.

In addition, the insulating sheet according to the present invention may contain additives such as a thixotropic agent, a dispersant, a flame retardant, and a coloring agent.

(Insulating sheet)

The insulating sheet according to the present invention may be produced by any method. For example, the insulating sheet may be provided by mixing the aforementioned materials to prepare a mixture and then forming the mixture into a sheet through solvent casting or extrusion film formation. It is preferable to perform deaeration at the time of the sheet formation.

The thickness of the insulating sheet is not particularly limited. The thickness of the insulating sheet is preferably 10 to 300 μm, more preferably 50 to 200 μm, and further preferably 70 to 120 μm. If the insulating sheet is too thin, the cured product of the insulating sheet may have poor insulating property. If the insulating sheet is too thick, the insulating sheet may have poor heat dissipation capability in the case of bonding a metal material to the electrically conductive layer.

A thick insulating sheet allows the cured product of the insulating sheet to have much better dielectric breakdown characteristics. Here, the insulating sheet according to the present invention allows the cured product of the insulating sheet to have high dielectric breakdown characteristics even when it is thin.

The insulating sheet has a glass transition temperature Tg of 25˚C or lower when it is uncured. An insulating sheet having a glass transition temperature of higher than 25˚C may be hard and brittle at room temperature. This may cause poor handleability of the uncured insulating sheet.

The insulating sheet has a bending modulus at 25˚C of preferably 10 to 1,000 MPa, and more preferably 20 to 500 MPa, when it is uncured. If the uncured insulating sheet has a bending modulus of lower than 10 MPa at 25˚C, the self supportability at room temperature of the uncured insulating sheet may be remarkably poor, and the handleability of the uncured insulating sheet may be poor. If the insulating sheet has a bending modulus at 25˚C of higher than 1,000 MPa, the elastic modulus of the insulating sheet may not be sufficiently low at the time of heat bonding. This may cause the cured product of the insulating sheet to insufficiently bond to an adherend, and the adhesion between the cured product of the insulating sheet and the adherend may be poor.

After the insulating sheet is cured, the cured product of the insulating sheet has a bending modulus at 25˚C of preferably 1,000 to 50,000 MPa, and more preferably 5,000 to 30,000 MPa. If the cured product of the insulating sheet has a too low bending modulus at 25˚C, a laminated structure formed by the use of the insulating sheet, such as a thin laminated substrate or a laminated plate with a copper circuit disposed on both of the surfaces, may be easily bent. Thus, the laminated structure is likely to be damaged due to folding or bending. If having a too high bending modulus at 25˚C, the cured product of the insulating sheet may be too hard and too brittle. Thus, the cured product of the insulating sheet is likely to suffer clacking.

For example, the bending modulus may be measured with a sample (length: 8cm, width: 1 cm, thickness: 4 mm) by means of a universal testing apparatus RTC-1310A (produced by ORIENTEC Co., Ltd.) at a span of 6 cm and a rate of 1.5 mm/min in accordance with JIS K 7111. For measuring of the bending modulus of the cured product of the insulating sheet, the cured product of the insulating sheet may be prepared by curing the insulating sheet at two temperature steps, that is, at 120˚C for one hour and then at 200˚C for one hour.

The insulating sheet according to the present invention preferably has a tanδ at 25˚C, measured with a rotating dynamic viscoelasticity measuring apparatus, of 0.1 to 1.0 when it is uncured, and the insulating sheet preferably has a maximum tanδ of 1.0 to 5.0 when the uncured insulating sheet is heated from 25˚C to 250˚C. The tanδ of the insulating sheet is more preferably 0.1 to 0.5. The maximum value of the tanδ of the insulating sheet is more preferably 1.5 to 4.0.

If the uncured insulating sheet has a tanδ at 25˚C of lower than 0.1, the uncured insulating sheet may have poor flexibility and is likely to be damaged. If the uncured insulating sheet has a tanδ at 25˚C of higher than 1.0, the uncured insulating sheet may be too soft, and the handleability of the uncured insulating sheet may be poor.

If the insulating sheet has a maximum tanδ of lower than 1.0 when the uncured insulating sheet is heated from 25˚C to 250˚C, the insulating sheet may insufficiently adhere to an adherend upon heat bonding. If the aforementioned maximum tanδ of the insulating sheet is higher than 5.0, the insulating sheet may have too high fluidity and the insulating sheet may be thin upon heat bonding. Thus, desired dielectric breakdown characteristics may not be obtained.

The tanδ at 25˚C of the uncured insulating sheet may be measured with a 2-cm diameter disc-shaped uncured insulating sheet by means of a rotating dynamic viscoelasticity measuring apparatus VAR-100 (produced by REOLOGICA Instruments AB) with a 2-cm diameter parallel plate at a temperature of 25˚C, an initial stress of 10 Pa, a frequency of 1 Hz, and a strain of 1% in an oscillation strain controlling mode. Further, the maximum value of the tanδ of the insulating sheet when the uncured insulating sheet is heated from 25˚C to 250˚C may be measured by heating the uncured insulating sheet from 25˚C to 250˚C at a heating rate of 30˚C/min under the aforementioned conditions.

In the case where the bending modulus and the tanδ each are in the aforementioned specific range, the handleability of the uncured insulating sheet is remarkably high at the time of the production and the use thereof. Further, the bonding strength of the insulating sheet is remarkably high in the case of bonding a high-heat conductor such as a copper foil or an aluminum plate to the electrically conductive layer. Furthermore, in the case where the high-heat conductor has projected and recessed portions on its bonded surface, the insulating sheet is allowed to highly follow the projected and recessed portions. Thus, voids are less likely to be formed at the bonding interface, so that the insulating sheet is allowed to have higher thermal conductivity.

The cured product of the insulating sheet has a thermal conductivity of preferably 3.0 W/m·K or higher, more preferably 5.0 W/m·K or higher, and further preferably 7.0 W/m·K or higher. A cured product of the insulating sheet having a too low thermal conductivity may have insufficient heat dissipation capability.

The cured product of the insulating sheet has a dielectric breakdown voltage of preferably 30 kV/mm or higher, more preferably 40 kV/mm or higher, further preferably 50 kV/mm or higher, furthermore preferably 80 kV/mm or higher, and still more preferably 100 kV/mm or higher. An insulating sheet having a too low dielectric breakdown voltage may exert an insufficient insulating property when used in large-current applications such as electric power elements.

The cured product of the insulating sheet has a volume resistivity of preferably $10^{14}$ Ω·cm or higher, and more preferably $10^{16}$ Ω·cm or higher. If the volume resistivity is too low, insulation between the electrically conductive layer

and the heat conductor may not be retained.

The cured product of the insulating sheet has a coefficient of linear thermal expansion of preferably 30 ppm/˚C or lower, and more preferably 20 ppm/˚C or lower. A cured product of the insulating sheet having a too high coefficient of linear thermal expansion may have poor temperature cycle resistance.

(Multilayer structure)

The insulating sheet according to the present invention is used for bonding the heat conductor having a thermal conductivity of 10 W/m·K or higher to the electrically conductive layer. Further, the insulating sheet according to the present invention is suitably used as the material of an insulating layer of the multilayer structure in which the electrically conductive layer is laminated on at least one side of the heat conductor having a thermal conductivity of 10 W/m·K or higher via the insulating layer.

Fig. 1 is a multilayer structure according to one embodiment of the present invention.

A multilayer structure 1 illustrated in Fig. 1 includes a heat conductor 2; an insulating layer 3 laminated on one side 2a of the heat conductor 2; and an electrically conductive layer 4 laminated on the insulating layer 3 on the other side of the insulating sheet. The insulating layer 3 is formed by curing the insulating sheet according to the present invention. The heat conductor 2 has a thermal conductivity of 10 W/m·K or higher.

The multilayer structure 1 has the insulating layer 3 and the electrically conductive layer 4 in the stated order at least on the one side 2a of the heat conductor 2. The multilayer structure may have an insulating layer and an electrically conductive layer in the stated order also on the other side 2b of the heat conductor 2.

The insulating layer 3 of the multilayer structure 1 has high thermal conductivity, and heat from the electrically conductive layer 4 side is easily transmitted through the insulating layer 3 to the heat conductor 2. In the multilayer structure 1, the heat conductor 2 enables heat to be sufficiently dissipated.

For example, the multilayer structure 1 may be provided by bonding a metal material to an electrically conductive layer, such as a multilayer plate or a multilayer wiring board with copper circuits provided on both sides thereof, a copper foil, a copper plate, a semiconductor element, or a semiconductor package, via the insulating sheet, and then curing the insulating sheet.

The heat conductor having the thermal conductivity of 10 W/m·K or higher is not particularly limited. Examples of the heat conductor having a thermal conductivity of 10 W/m·K or higher include aluminum, copper, alumina, beryllia, silicon carbide, silicon nitride, aluminum nitride, and a graphite sheet. In particular, the heat conductor having a thermal conductivity of 10 W/m·K or higher is preferably copper or aluminum. Copper and aluminum are excellent in heat dissipation capability.

The insulating sheet of the present invention is suitably used for bonding a heat conductor having a thermal conductivity of 10 W/m·K or higher to an electrically conductive layer of a semiconductor device with a semiconductor element mounted on a substrate. The insulating sheet of the present invention is also suitably used for bonding a heat conductor having a thermal conductivity of 10 W/m·K or higher to an electrically conductive layer of an electronic component device with an electronic component other than semiconductor elements mounted on a substrate.

In the case where the semiconductor element is a power supply device element for large current applications, a cured product of the insulating sheet is required to have a much more excellent insulating property or heat resistance. Thus, the insulating sheet of the present invention is suitably used in such applications.

The present invention is clearly disclosed hereinbelow with reference to, but not limited to, specific examples and comparative examples.

The following materials were prepared.

[Polymer (A)]

(1) Bisphenol A phenoxy resin (product of Japan Epoxy Resins Co., Ltd., product name: E1256, Mw = 51,000, Tg = 98˚C)

(2) High heat resistant phenoxy resin (product of Tohto Kasei Co., Ltd., product name: FX-293, Mw = 43,700, Tg=163˚C)

(3) Epoxy-group containing styrene resin (product of NOF Corporation, product name: Marproof G-1010S, Mw = 100,000, Tg = 93˚C)

(4) Carboxyl-group containing acrylic resin (product of Shin-Nakamura Chemical Co., Ltd., product name: PSY-130, Mw = 30,000, Tg = 109˚C)

(5) Sulfonic-acid-group containing styrene resin (product of Nippon NSC Co., Ltd,, product name: VERSA-TL 72, Mw = 70,000, Tg = 98˚C)

(6) Phospholic-acid-group containing acrylic resin (synthesized in Synthesis Example 1, Mw = 12,000, Tg = 97˚C)

(Synthesis Example 1)

A flask having a thermometer, a stirrer, a dropping funnel, and a reflux condenser was charged with 0.7 mole of methyl methacrylate and 0.3 mole of glycidyl methacrylate, and then with methyl ethyl ketone as a solvent and azobisisobutyronitrile as a catalyst. The solution was stirred for 18 hours at 80˚C under nitrogen atmosphere. After that, the solution was cooled and methylhydroquinone as a polymerization inhibitor was added to the mixture. An amount of 1 mole of water was added to the solution, and the solution was stirred at 40˚C while 0.1 mole of phosphoric anhydride was gradually added to the solution. Thereafter, reaction was allowed to occur for three hours, and thereby a polymer solution containing phosphate groups was prepared.

[Polymer other than polymer (A)]

(1) Epoxy-group containing acrylic resin (product of NOF Corporation, product name: Marproof G-0130S, Mw = 9,000, Tg = 69˚C)

[Epoxy resin (B1)]

(1) Bisphenol A liquid epoxy resin (product of Japan Epoxy Resins Co., Ltd., product name: EPIKOTE 828US, Mw = 370, hydroxyl group equivalent: 3,000, theoretical chemical structure purity: 87%)
(2) Bisphenol F liquid epoxy resin (product of Japan Epoxy Resins Co., Ltd. , product name: EPIKOTE 806L, Mw = 370, hydroxyl group equivalent: 2,500, theoretical chemical structure purity: 87%)
(3) Trifunctional glycidyl amine liquid epoxy resin (product of Japan Epoxy Resins Co., Ltd., product name: EPIKOTE 630, Mw = 300, hydroxyl group equivalent: 3,700, theoretical chemical structure purity: 92%)
(4) Fluorene skeleton epoxy resin (product of Osaka Gas Chemicals Co., Ltd., product name: Oncoat EX1011, Mw = 486, hydroxyl group equivalent: 2,300, theoretical chemical structure purity: 81%)
(5) Naphthalene skeleton liquid epoxy resin (product of Dainippon Ink and Chemicals, Corp., product name: EPICLON HP-4032D, Mw = 304, hydroxyl group equivalent: 7,000, theoretical chemical structure purity: 98%)
(6) Hexahydro phthalate skeleton liquid epoxy resin (product of Nippon Kayaku Co. , Ltd. make, product name: AK-601, Mw = 284, hydroxyl group equivalent: 2,800, theoretical chemical structure purity: 90%)
(7) Bisphenol A solid epoxy resin (product of Japan Epoxy Resins Co. , Ltd. , product name: 1003, Mw = 1, 300, hydroxyl group equivalent: 380, a composition containing hydroxyl groups, low theoretical chemical structure purity due to the hydroxyl groups)
(8) Distilled bisphenol A liquid epoxy resin (product of Tohto Kasei Co. , Ltd. product name: YD-8125, Mw = 350, hydroxyl group equivalent: 17,000, theoretical chemical structure purity: 99%)

[Oxetane resin (B-2)]

(1) Benzene skeleton oxetane resin (product of Ube Industries, Ltd., product name: ETERNACOLL OXTP, Mw = 362.4, hydroxyl group equivalent: 6,500, theoretical chemistry structure purity: 97%)

[Curing agent (C)]

(1) Alicyclic skeleton acid anhydride (product of New Japan Chemical Co., Ltd., product name: MH-700)
(2) Aromatic skeleton acid anhydride (product of Sartomer Japan Inc., product name: SMA resin EF60)
(3) Polyalicyclic skeleton acid anhydride (product of New Japan Chemical Co., Ltd., product name: HNA-100)
(4) Terpene skeleton acid anhydride (product of Japan Epoxy Resins Co., Ltd., product name: EPIKURE YH-306)
(5) Biphenyl skeleton phenol resin (product of Meiwa Plastic Industries, Ltd., product name: MEH-7851-S)
(6) Allyl skeleton phenol resin (product of Japan Epoxy Resins Co., Ltd., product name: YLH-903)
(7) Triazine skeleton phenol resin (product of Dainippon Ink and Chemicals, Corp., product name: PHENOLITE KA-7052-L2)
(8) Melamine skeleton phenol resin (Gunei Chemical Industry Co., Ltd., product name: PS-6492)
(9) Isocyanurate-modified solid dispersed imidazole (imidazole curing accelerator, product of Shikoku Chemicals

Corp., product name: 2MZA-PW)

[Magnesium carbonate anhydride (D1)]

(1) 6-μm substantially polyhedral synthetic magnesite (product of Konoshima Chemical Co. Ltd., product name: MSL, average particle size: 6 μm)
(2) 21-μm substantially polyhedral synthetic magnesite (product of Konoshima Chemical Co. Ltd., product name: MSPS, average particle size: 21 μm)
(3) 6-μm spherical synthetic magnesite A (magnesium carbonate anhydride (D1d))

A substantially polyhedral synthetic magnesite (product of Konoshima Chemical Co. Ltd., product name: MSL, average particle size: 6 μm) was crushed by a fluidized bed-counter jet mill (product of EARTHTECHNICA Co. Ltd., product name: JEDI) and then spheroidized, so that a 6-μm spherical synthetic magnesites A was produced.

(4) 21-μm spherical synthetic magnesite A (magnesium carbonate anhydride (D1d))
A 21-μm spherical synthetic magnesites A was produced by the same procedure as for the 6-μm spherical synthetic magnesites A, except that a substantially polyhedral synthetic magnesite (product of Konoshima Chemical Co. Ltd., product name: MSPS, average particle size: 21 μm) was used in place of the above substantially polyhedral synthetic magnesite (product of Konoshima Chemical Co. Ltd., product name: MSL, average particle size: 6 μm).

(5) 6-μm spherical synthetic magnesite B (magnesium carbonate anhydride (D1d))
A substantially polyhedral synthetic magnesite (product of Konoshima Chemical Co. Ltd., product name: MSL, average particle size: 6 μm) was crushed by a continuous particle surface modifying system (product of EARTHTECHNICA Co. Ltd., product name: KRYPTRON Orb) and then spheroidized, so that a 6-μm spherical synthetic magnesite B was produced.

(6) 21-μm spherical synthetic magnesite B (magnesium carbonate anhydride (D1d))
A 21-μm spherical synthetic magnesite B was produced by the same procedure as for the 6-μm spherical synthetic magnesite B, except that a substantially polyhedral synthetic magnesite (product of Konoshima Chemical Co. Ltd., product name: MSPS, average particle size: 21 μm) was used in place of the above substantially polyhedral synthetic magnesite (product of Konoshima Chemical Co. Ltd., product name: MSL, average particle size: 6 μm).

[Coated body (D2)]

(Synthesis Example 2)

A 2-L polymerization vessel having a stirrer, a jacket, a reflux condenser, and a thermometer was charged with 1000 g of methyl isobutyl ketone as a dispersion medium, 600 g of a substantially polyhedral synthetic magnesite (product of Konoshima Chemical Co. Ltd., product name: MSL, average particle size: 6 μm), 50 g of dipentaerythritol hexamethacrylate, and 1 g of azobisisobutyronitrile. Then, the solution was stirred to be mixed, so that a dispersion liquid was prepared which had the magnesite dispersed in surface treatment solution. The vessel was decompressed for deoxygenation and then nitrogen was put into the vessel to bring the pressure back to the atmospheric pressure, so that the container had a nitrogen atmosphere. Thereafter, the vessel was heated to 70°C while the solution was stirred, allowing the reaction to occur for eight hours. After the vessel was cooled to room temperature, the reaction solution was desolventized by centrifugation and then the resulting solid material was vacuum-dried. Thereby, a 6-μm synthetic magnesite having the surface coated by a methacrylic resin (acrylic-resin coated 6-μm synthetic magnesite) was produced.

(Synthetic Example 3)

A 6-μm synthetic magnesite having the surface thereof coated by a silicone resin (silicone-resin coated 6-μm synthetic magnesite) was produced by the same procedure for Synthesis Example 1, except that a silicone having methacryloxy groups at both ends (SILAPLANE FM-7721) was used as a monomer for coating the surface in place of dipentaerythritol hexamethacrylate.

(Synthetic Example 4)

A 2-L polymerization vessel having a stirrer, a jacket, a reflux condenser, and a thermometer was charged with 1000 g of ion-exchanged water having a controlled pH of 9 as a dispersion medium, 600 g of substantially polyhedral synthetic magnesite (product of Konoshima Chemical Co. Ltd., product name: MSL, average particle size: 6 μm), and

60 g of tetraethoxysilane. After that, the solution was stirred to be mixed, so that a dispersion liquid was prepared which had the magnesite dispersed in a surface treatment solution. Thereafter, the vessel was heated to 70˚C while the solution was stirred, allowing the reaction to occur for eight hours. After the vessel was cooled to room temperature, the reaction solution was desolventized by centrifugation and then the resulting solid material was vacuum-dried. Thereby, a 6-μm synthetic magnesite having the surface thereof coated by silica (silica-coated 6-μm synthetic magnesite) was produced.

(Synthesis Example 5):(Coated body (D2d))

A 2-L polymerization vessel having a stirrer, a jacket, a reflux condenser, and a thermometer was charged with 1000 g of ion-exchanged water having a controlled pH of 9 as a dispersion medium, 600 g of the above 6-μm spherical synthetic magnesite B, and 60 g of tetraethoxysilane. Then, the solution was stirred to be mixed, so that a dispersion liquid was prepared which had the magnesite dispersed in a surface treatment solution. Thereafter, the vessel was heated to 70˚C while the solution was stirred, allowing the reaction to occur for eight hours. After the vessel was cooled to room temperature, the reaction solution was desolventized by centrifugation and then the resulting solid material was vacuum-dried. Thereby, a 6-μm spherical synthetic magnesite having the surface coated by silica (silica-coated 6-μm synthetic magnesite) was produced.

[Filler other than substance (D) (inorganic filler (G))]

(1) 1.1-μm magnesium oxide (product of Sakai Chemical Industry Co., Ltd., product name: SMO, average particle size: 1.1 μm)
(2) Crystal-water containing 9-μm magnesium carbonate (product of Konoshima Chemical Co. Ltd., product name: GP-30, average particle size: 9 μm)
(3) Spherical alumina having an average particle size of 0.4 μm (product of Sumitomo Chemical Co., Ltd., product name: AKP-30)
(4) Spherical aluminum nitride having an average particle size of 30 μm (product of Toyo Aluminium K.K., product name: TOYALNITE-FLD)
(5) Plate boron nitride having an average length of 8 μm (product of Showa Denko K.K., product name: UHP-1, aspect ratio: 30 to 50)
(6) Plate silicon carbide having an average length of 0.7 μm (product of TOMOE Engineering Co., Ltd., product name: HSC-490N, aspect ratio: 5 to 10)
(7) Crystalline silica having an average particle size of 20 μm (product of Tatsumori Ltd., product name: CRYSTALITE C)
(8) Amorphous silica having an average particle size of 15 μm (product of Tokuyama Corp., product name: SE-15)
(9) Plate alumina having an average length of 2 μm (product of Kinsei Matec Co., Ltd., product name: Serath 02025, aspect ratio: 20 to 30)

[Dispersant (F)]

(1) Acrylic dispersant (product of BYK Japan KK, product name: Disperbyk-2070, having carboxyl groups with a pKa value of 4)
(2) Polyether dispersant (product of Kusumoto Chemicals, Ltd., product name: ED151, having phosphate groups with a pKa value of 7)

[Dispersant other than dispersant (F)]

(1) Nonion dispersant (product of KYOEISHA CHEMICAL Co., Ltd., product name: D-90, a dispersant not having a hydrogen-bonding functional group containing a hydrogen atom)

[Additive]

(1) Epoxy silane coupling agent (product of Shin-Etsu Chemical Co., Ltd., product name: KBE403)

[Solvent]

(1) Methylethyl ketone

(Example 1)

The materials were blended with one another and kneaded at a ratio (the unit for blending is part(s) by weight) shown in the following Table 1 with a homodisper to prepare an insulating material.

The prepared insulating material was applied to a 50-μm thick release PET sheet so that the thickness of the insulating material was 100 μm. The applied insulating material was dried for 30 minutes in a 90˚C oven to prepare an insulating sheet on the PET sheet.

(Examples 2 to 21 and Comparative Examples 1 to 3)

Except that the kinds and amounts of the compounds were changed as shown in the following Tables 1 to 3, insulating materials were prepared in the same manner as in Example 1 and insulating sheets each were prepared on the PET film.

(Evaluations for Examples 2 to 21 and Comparative Examples 1 to 3)

The respective insulating sheets prepared were evaluated.

(1) Handleability

Each multilayer sheet including the PET sheet and the insulating sheet formed on the PET sheet was cut out into a plane shape having a size of 460 mm × 610 mm to provide a test sample. By the use of the provided test sample, the handleability upon peeling the uncured insulating sheet off the PET sheet at room temperature (23˚C) was evaluated on the following criteria.

[Evaluation criteria of handleability]

○○ (double circle) : The insulating sheet was not deformed and was easily peeled off. The sheet had flexibility and was therefore not broken when it received a shock.
○: The insulating sheet was not deformed and was easily peeled off.
△: The insulating sheet was peeled off, but the sheet was elongated or broken.

×: The insulating sheet was not peeled off.

(2) Sheet property of insulating sheet after storage

Each uncured insulating sheet was stored for six months at 23˚C and a relative humidity of 50%. The insulating sheet was visually observed before and after the storage, and the sheet property of the sheet was evaluated on the following criteria.

[Evaluation criteria of sheet property]

○○ (double circle): The insulating sheet did not change at all before and after the storage.
○: The insulating sheet did not change much but was slightly hard and brittle after the storage.
△: The insulating sheet was hard and brittle after the storage, and had to be handled with care.
×: The insulating sheet could not be treated as an insulating sheet after the storage.

(3) Glass transition temperature

The glass transition temperature of each uncured insulating sheet was measured at a temperature-rise rate of 30˚C/min. with a differential scanning calorie measuring apparatus "DSC220C" produced by Seiko Instruments Inc.

(4) Thermal conductivity

Each insulating sheet was heated for one hour in a 120˚C oven and then for one hour in a 200˚C oven, so that the insulating sheet was cured. The thermal conductivity of the insulating sheet was measured with a thermal conductivity meter "Quick Thermal Conductivity Meter QTM-500" produced by Kyoto Electronics Manufacturing Co., Ltd.

(5) Dielectric breakdown voltage

Each insulating sheet was cut out into a plane shape having a size of 100 mm × 100 mm to prepare a test sample. The prepared test sample was cured for one hour in a 120˚C oven and for one hour in a 200˚C oven to prepare a cured product of the insulating sheet. The cured product of the insulating sheet was subjected to an application of an alternating voltage so that the voltage rose at a rate of 1 kV/sec. with a voltage resistance testing apparatus (MODEL7473, produced by EXTECH Electronics). The voltage at which the insulating sheet was broken was regarded as a dielectric breakdown voltage.

(6) Solder heat resistance

Each insulating sheet was sandwiched between a 1.5-mm thick aluminum plate and a 35-μm thick electrolytic copper foil. Then, the insulating sheet was press-cured at 120˚C for one hour and at 200˚C for another one hour while the pressure was retained at 4 MPa with a vacuum press to prepare a copper clad laminated plate. The prepared copper clad laminated plate was cut out into a size of 50 mm × 60 mm to prepare a test sample. The prepared test sample was allowed to float on a 288˚C solder bath so that the copper foil side was put downward. The time period until the copper foil was expanded or peeled off was measured, and the solder heat resistance was evaluated on the following criteria.

[Evaluation criteria of solder heat resistance]

○: No expansion or peeling occurred even after three minutes.
△: Expansion or peeling occurred after one minute and before three minutes.
×: Expansion or peeling occurred before one minute.

(7) Acid resistance

Each insulating sheet was cut out into a plane shape having a size of 100 mm × 100 mm to prepare a test sample. The prepared test sample was cured for one hour in a 120˚C oven and for one hour in a 200˚C oven. The prepared sample was soaked in a hydrochloric acid solution having a pH of 2. 0 and heated to 50˚C, for three hours. Thereafter, the weight loss of the sample was determined and the surface condition of the sample was observed to evaluate the acid resistance of the sample based on the following criteria.

[Evaluation criteria of acid resistance]

○: No surface condition change with a weight loss of less than 1%.
△: The weight loss was less than 1%, but irregularities caused by melting of magnesite were observed on the surface of the insulating sheet.
×: The weight loss was 1% or more, and irregularities were observed on the surface of the insulating sheet.

(8) Processability

Each insulating sheet was sandwiched between a 1.5-mm thick aluminum plate and a 35-μm thick electrolytic copper foil. Then, the insulating sheet was press-cured at 120˚C for one hour and at 200˚C for another one hour while the pressure was retained at 4 MPa with a vacuum press to prepare a copper clad laminated plate. The prepared copper clad laminated plate was router-processed with a 2.0-mm diameter drill (produced by Union Tool Co., RA series) at a rotational speed of 30,000 and a table feed speed of 0.5 m/min. The processing distance at which a burr generated was measured, and the processability was evaluated on the following criteria.
○: Processable for 5 m or more without a burr.
△: Processable for 1 m or more and less than 5 m without a burr.
×: Processing for less than 1 m caused a burr.

(9) Bending modulus

A sample piece (length: 8 cm, width: 1 cm, thickness: 4 mm) was subjected to a measurement at a span of 6 cm and at a rate of 1.5 mm/min. with a universal tester RTC-1310A (produced by ORIENTEC Co. , Ltd.) in accordance with JIS K 7111. Thereby, the bending modulus at 25˚C of the uncured insulating sheet was measured.
Then, the insulating sheet was cured at 120˚C for one hour and then at 200˚C for one hour to provide a cured product of the insulating sheet. In the same manner as for the uncured insulating sheet, the sample piece (length: 8 cm, width: 1 cm, thickness: 4 mm) was subjected to a measurement at a span of 6 cm and at a rate of 1.5 mm/min. with a universal tester (produced by ORIENTEC Co. , Ltd.) in accordance with JIS K 7111. Thus, the bending modulus at 25˚C of the cured product of the insulating sheet was measured.

(10) Elastic modulus

A 2-cm diameter disc-shaped sample of the uncured insulating sheet was prepared, and the tanδ at 25˚C of the uncured insulating sheet was measured by means of a rotating dynamic viscoelasticity measuring apparatus VAR-100 (produced by REOLOGICA Instruments AB) with a 2-cm diameter parallel plate at a temperature of 25˚C, an initial stress of 10 Pa, a frequency of 1 Hz, and a strain of 1% in an oscillation strain controlling mode. Further, the maximum value of tanδ of the insulating sheet when the uncured insulating sheet was heated from 25˚C to 250˚C was measured by heating the uncured insulating sheet sample from 25˚C to 250˚C at a heating rate of 30˚C/min. under the aforementioned conditions.
Tables 1 to 3 show the results.
[Table 1]

| | | | Examples | | | | | | | |
|---|---|---|---|---|---|---|---|---|---|---|
| | | | 1 | 2 | 3 | 4 | 5 | 6 | 7 | 8 |
| Components (parts by weight) | Polymer (A) | Bisphenol A phenoxy resin | 6 | 8 | 12 | | | 6 | 6 | 6 |
| | | Highly heat-resistant phenoxy resin | | | | 6 | | | | |
| | | Epoxy group-containing styrene resin | | | | | 6 | | | |
| | Polymer other than polymer (A) | Epoxy group-containing acrylic resin | | | | | | | | |
| | Epoxy resin (B1) | Bisphenol A liquid epoxy resin | 3 | 4 | 6 | 3 | 3 | | | |
| | | Bisphenol F liquid epoxy resin | | | | | | 3 | | |
| | | Trifunctional glycidyl diamine liquid epoxy resin | | | | | | | 3 | |
| | | Fluorene skeleton epoxy resin | | | | | | | | 3 |
| | | Naphthalene skeleton liquid epoxy resin | | | | | | | | |
| | | Hexahydrophthalate skeleton liquid epoxy resin | 0.75 | 1 | 1.5 | 0.75 | 0.75 | 0.75 | 0.75 | 0.75 |
| | | Bisphenol A solid epoxy resin | | | | | | | | |
| | Oxetane resin (B2) | Benzene-skeleton containing oxetane resin | | | | | | | | |
| | Curing agent (C) | Alicyclic skeleton acid anhydride | 3 | 4 | 6 | 3 | 3 | 3 | 3 | 3 |
| | | Aromatic skeleton acid anhydride | | | | | | | | |
| | | Polyalicyclic skeleton acid anhydride | | | | | | | | |
| | | Terpene skeleton acid anhydride | | | | | | | | |
| | | Biphenyl skeleton phenol resin | | | | | | | | |
| | | Allyl skeleton phenol resin | | | | | | | | |
| | | Triazine skeleton phenol resin | | | | | | | | |
| | | Melamine skeleton phenol resin | | | | | | | | |
| | | Isocyanurate-modified solid dispersed imidazole | 0.75 | 1 | 1.5 | 0.75 | 0.75 | 0.75 | 0.75 | 0.75 |
| | Magnesium carbonate anhydrous (D1) | 6-μm substantially polyhedral synthetic magnesite | 65 | 70 | 70 | 65 | 65 | 65 | 65 | 65 |
| | | 21-μm substantially polyhedral synthetic magnesite | 20 | 10 | | 20 | 20 | 20 | 20 | 20 |
| | Coated body (D2) | 6-μm acrylic resin-coated synthetic magnesite | | | | | | | | |
| | | 6-μm silicone resin-coated synthetic magnesite | | | | | | | | |
| | | 6-μm silica-coated synthetic magnesite | | | | | | | | |
| | Filler other than substance (D) | 1.1-μm Magnesium oxide | | | | | | | | |
| | | 9-μm crystal water-containing magnesium carbonate | | | | | | | | |
| | Additive | Epoxy silane coupling agent | 1.5 | 2 | 3 | 1.5 | 1.5 | 1.5 | 1.5 | 1.5 |
| | Solvent | Methylethyl ketone | 20 | 20 | 20 | 20 | 20 | 20 | 20 | 20 |
| Amount of polymer (A) (% by weight) *1 | | | 40 | 40 | 40 | 40 | 40 | 40 | 40 | 40 |
| Amount of resin (B) (% by weight) *1 | | | 25 | 25 | 25 | 25 | 25 | 25 | 25 | 25 |
| Amount of curing agent (C) (% by weight) *1 | | | 25 | 25 | 25 | 25 | 25 | 25 | 25 | 25 |
| Amount of substance (D) (% by volume) *2 | | | 69 | 62 | 48 | 69 | 69 | 69 | 69 | 69 |
| Evaluation | Handleability | | ○ | ○ | ○ | ○ | ○ | ○ | ○ | ○ |
| | Sheet property after storage | | ○ | ○ | ○ | ○ | ○ | ○ | ○ | ○ |
| | Glass transition temperature (℃) | | 13 | 14 | 12 | 10 | 14 | 11 | 12 | 14 |
| | Thermal conductivity (W/m•K) | | 3 | 2.5 | 2 | 3.3 | 3.2 | 3 | 3.1 | 3.4 |
| | Dielectric breakdown voltage (kV/mm) | | 42 | 58 | 62 | 51 | 48 | 40 | 45 | 50 |
| | Solder heat resistance (288℃) | | ○ | ○ | ○ | ○ | ○ | ○ | ○ | ○ |
| | Acid resistance | | ○ | ○ | ○ | ○ | ○ | ○ | ○ | ○ |
| | Processability | | ○ | ○ | ○ | ○ | ○ | ○ | ○ | ○ |
| | Bending modulus at 25℃ of uncured insulating sheet (MPa) | | 250 | 140 | 110 | 300 | 280 | 200 | 210 | 340 |
| | Bending modulus at 25℃ of cured product of insulating sheet (MPa) | | 25000 | 16000 | 14000 | 27000 | 26000 | 21000 | 26000 | 28000 |
| | tanδ at 25℃ of uncured insulating sheet *3 | | 0.3 | 0.4 | 0.4 | 0.3 | 0.3 | 0.3 | 0.3 | 0.2 |
| | Maximum value of tanδ at 25℃ to 250℃ of uncured insulating sheet *3 | | 1.4 | 1.5 | 1.5 | 1.3 | 1.3 | 1.4 | 1.3 | 1.2 |

*1 The amount in 100% by weight of all the resin components in the insulating sheet

*2 The amount in 100% by volume of the insulating sheet

*3 Measured with a rotating dynamic viscoelasticity measuring apparatus

[Table 2]

| | | | Examples | | | | | | | |
|---|---|---|---|---|---|---|---|---|---|---|
| | | | 9 | 10 | 11 | 12 | 13 | 14 | 15 | 16 |
| Components (parts by weight) | Polymer (A) | Bisphenol A phenoxy resin | 6 | 6 | 6 | 6 | 6 | 6 | 6 | 6 |
| | | Highly heat-resistant phenoxy resin | | | | | | | | |
| | | Epoxy group-containing styrene resin | | | | | | | | |
| | Polymer other than polymer (A) | Epoxy group-containing acrylic resin | | | | | | | | |
| | Epoxy resin (B1) | Bisphenol A liquid epoxy resin | | | 3 | 3 | 3 | 3 | 3 | 3 |
| | | Bisphenol F liquid epoxy resin | | | | | | | | |
| | | Trifunctional glycidyl diamine liquid epoxy resin | | | | | | | | |
| | | Fluorene skeleton epoxy resin | | | | | | | | |
| | | Naphthalene skeleton liquid epoxy resin | 3 | | | | | | | |
| | | Hexahydrophthalate skeleton liquid epoxy resin | 0.75 | 0.75 | 0.75 | 0.75 | 0.75 | 0.75 | 0.75 | 0.75 |
| | | Bisphenol A solid epoxy resin | | | | | | | | |
| | Oxetane resin (B2) | Benzene-skeleton containing oxetane resin | | 3 | | | | | | |
| | Curing agent (C) | Alicyclic skeleton acid anhydride | 3 | 3 | | | | | | |
| | | Aromatic skeleton acid anhydride | | | 3 | | | | | |
| | | Polyalicyclic skeleton acid anhydride | | | | 3 | | | | |
| | | Terpene skeleton acid anhydride | | | | | 3 | | | |
| | | Biphenyl skeleton phenol resin | | | | | | 3 | | |
| | | Allyl skeleton phenol resin | | | | | | | 3 | |
| | | Triazine skeleton phenol resin | | | | | | | | 3 |
| | | Melamine skeleton phenol resin | | | | | | | | |
| | | Isocyanurate-modified solid dispersed imidazole | 0.75 | 0.75 | 0.75 | 0.75 | 0.75 | 0.75 | 0.75 | 0.75 |
| | Magnesium carbonate anhydrous (D1) | 6-μm substantially polyhedral synthetic magnesite | 65 | 65 | 65 | 65 | 65 | 65 | 65 | 65 |
| | | 21-μm substantially polyhedral synthetic magnesite | 20 | 20 | 20 | 20 | 20 | 20 | 20 | 20 |
| | Coated body (D2) | 6-μm acrylic resin-coated synthetic magnesite | | | | | | | | |
| | | 6-μm silicone resin-coated synthetic magnesite | | | | | | | | |
| | | 6-μm silica-coated synthetic magnesite | | | | | | | | |
| | Filler other than substance (D) | 1.1-μm Magnesium oxide | | | | | | | | |
| | | 9-μm crystal water-containing magnesium carbonate | | | | | | | | |
| | Additive | Epoxy silane coupling agent | 1.5 | 1.5 | 1.5 | 1.5 | 1.5 | 1.5 | 1.5 | 1.5 |
| | Solvent | Methylethyl ketone | 20 | 20 | 20 | 20 | 20 | 20 | 20 | 20 |
| Amount of polymer (A) (% by weight) *1 | | | 40 | 40 | 40 | 40 | 40 | 40 | 40 | 40 |
| Amount of resin (B) (% by weight) *1 | | | 25 | 25 | 25 | 25 | 25 | 25 | 25 | 25 |
| Amount of curing agent (C) (% by weight) *1 | | | 25 | 25 | 25 | 25 | 25 | 25 | 25 | 25 |
| Amount of substance (D) (% by volume) *2 | | | 69 | 69 | 69 | 69 | 69 | 69 | 69 | 69 |
| Evaluation | Handleability | | ◎ | ◎ | ○ | ○ | ○ | ○ | ○ | ○ |
| | Sheet property after storage | | ◎ | ◎ | ○ | ○ | ○ | ○ | ○ | ○ |
| | Glass transition temperature (°C) | | 11 | 8 | 16 | 15 | 9 | 18 | 6 | 10 |
| | Thermal conductivity (W/m•K) | | 3.4 | 3.2 | 3.1 | 3.2 | 3.2 | 3 | 3 | 3 |
| | Dielectric breakdown voltage (kV/mm) | | 51 | 44 | 46 | 48 | 48 | 50 | 42 | 45 |
| | Solder heat resistance (288°C) | | ○ | ○ | ○ | ○ | ○ | ○ | ○ | ○ |
| | Acid resistance | | ○ | ○ | ○ | ○ | ○ | ○ | ○ | ○ |
| | Processability | | ○ | ○ | ○ | ○ | ○ | ○ | ○ | ○ |
| | Bending modulus at 25°C of uncured insulating sheet (MPa) | | 190 | 200 | 310 | 190 | 180 | 420 | 250 | 260 |
| | Bending modulus at 25°C of cured product of insulating sheet (MPa) | | 24000 | 18000 | 28000 | 20000 | 18000 | 30000 | 23000 | 27000 |
| | $\tan\delta$ at 25°C of uncured insulating sheet *3 | | 0.3 | 0.3 | 0.3 | 0.4 | 0.5 | 0.2 | 0.4 | 0.3 |
| | Maximum value of $\tan\delta$ at 25°C to 250°C of uncured insulating sheet *3 | | 1.3 | 1.7 | 1.3 | 1.4 | 1.7 | 1.2 | 1.4 | 1.3 |

*1 The amount in 100% by weight of all the resin components in the insulating sheet

*2 The amount in 100% by volume of the insulating sheet

*3 Measured with a rotating dynamic viscoelasticity measuring apparatus

[Table 3]

| | | | Examples | | | | | Comp. Exs. | | |
|---|---|---|---|---|---|---|---|---|---|---|
| | | | 17 | 18 | 19 | 20 | 21 | 1 | 2 | 3 |
| Components (parts by weight) | Polymer (A) | Bisphenol A phenoxy resin | 6 | 12 | 12 | 12 | 6 | 6 | 6 | |
| | | Highly heat-resistant phenoxy resin | | | | | | | | |
| | | Epoxy group-containing styrene resin | | | | | | | | |
| | Polymer other than polymer (A) | Epoxy group-containing acrylic resin | | | | | | | | 6 |
| | Epoxy resin (B1) | Bisphenol A liquid epoxy resin | 3 | 6 | 6 | 6 | | 3 | 3 | 3 |
| | | Bisphenol F liquid epoxy resin | | | | | | | | |
| | | Trifunctional glycidyl diamine liquid epoxy resin | | | | | | | | |
| | | Fluorene skeleton epoxy resin | | | | | | | | |
| | | Naphthalene skeleton liquid epoxy resin | | | | | | | | |
| | | Hexahydrophthalate skeleton liquid epoxy resin | 0.75 | 1.5 | 1.5 | 1.5 | 0.75 | 0.75 | 0.75 | 0.75 |
| | | Bisphenol A solid epoxy resin | | | | | 3 | | | |
| | | Distilled bisphenol A liquid epoxy resin | | | | | | | | |
| | Oxetane resin (B2) | Benzene-skeleton containing oxetane resin | | | | | | | | |
| | Curing agent (C) | Alicyclic skeleton acid anhydride | | 6 | 6 | 6 | 3 | 3 | 3 | 3 |
| | | Aromatic skeleton acid anhydride | | | | | | | | |
| | | Polyalicyclic skeleton acid anhydride | | | | | | | | |
| | | Terpene skeleton acid anhydride | | | | | | | | |
| | | Biphenyl skeleton phenol resin | | | | | | | | |
| | | Allyl skeleton phenol resin | | | | | | | | |
| | | Triazine skeleton phenol resin | | | | | | | | |
| | | Melamine skeleton phenol resin | 3 | | | | | | | |
| | | Isocyanurate-modified solid dispersed imidazole | 0.75 | 1.5 | 1.5 | 1.5 | 0.75 | 0.75 | 0.75 | 0.75 |
| | Magnesium carbonate anhydrous (D1) | 6-μm substantially polyhedral synthetic magnesite | 65 | | | | 65 | | | 65 |
| | | 21-μm substantially polyhedral synthetic magnesite | 20 | | | | 20 | | | 20 |
| | Coated body (D2) | 6-μm acrylic resin-coated synthetic magnesite | | 70 | | | | | | |
| | | 6-μm silicone resin-coated synthetic magnesite | | | 70 | | | | | |
| | | 6-μm silica-coated synthetic magnesite | | | | 70 | | | | |
| | Filler other than substance (D) | 1.1-μm Magnesium oxide | | | | | | 85 | | |
| | | 9-μm crystal water-containing magnesium carbonate | | | | | | | 85 | |
| | Additive | Epoxy silane coupling agent | 1.5 | 3 | 3 | 3 | 1.5 | 1.5 | 1.5 | 1.5 |
| | Solvent | Methylethyl ketone | 20 | 20 | 20 | 20 | 20 | 20 | 20 | 20 |
| Amount of polymer (A) (% by weight) *1 | | | 40 | 40 | 40 | 40 | 40 | 40 | 40 | – |
| Amount of resin (B) (% by weight) *1 | | | 25 | 25 | 25 | 25 | 25 | 25 | 25 | 25 |
| Amount of curing agent (C) (% by weight) *1 | | | 25 | 25 | 25 | 25 | 25 | 25 | 25 | 25 |
| Amount of substance (D) (% by volume) *2 | | | 69 | 48 | 48 | 48 | 69 | – | – | 69 |
| Evaluation | Handleability | | ○ | ○ | ○ | ○ | △ | ○ | ○ | × |
| | Sheet property after storage | | ○ | ○ | ○ | ○ | △ | ○ | ○ | × |
| | Glass transition temperature (℃) | | 12 | 11 | 10 | 11 | 34 | 14 | 11 | 2 |
| | Thermal conductivity (W/m•K) | | 3.2 | 2 | 2 | 2 | 3.1 | 3.7 | 2.7 | - |
| | Dielectric breakdown voltage (kV/mm) | | 52 | 65 | 58 | 60 | 41 | 36 | 28 | - |
| | Solder heat resistance (288℃) | | ○ | ○ | ○ | ○ | ○ | ○ | × | - |
| | Acid resistance | | ○ | ○ | ○ | ○ | ○ | × | △ | ○ |
| | Processability | | ○ | ○ | ○ | ○ | ○ | × | ○ | ○ |
| | Bending modulus at 25℃ of uncured insulating sheet (MPa) | | 280 | 100 | 90 | 120 | 520 | 270 | 270 | 8 |
| | Bending modulus at 25℃ of cured product of insulating sheet (MPa) | | 29000 | 13000 | 11000 | 15000 | 38000 | 26000 | 28000 | 800 |
| | tan$\delta$ at 25℃ of uncured insulating sheet *3 | | 0.2 | 0.5 | 0.6 | 0.3 | 0.1 | 0.3 | 0.3 | 1.2 |
| | Maximum value of tan$\delta$ at 25℃ to 250℃ of uncured insulating sheet *3 | | 1.2 | 1.6 | 1.6 | 1.3 | 1 | 1.3 | 1.3 | 5.1 |

*1 The amount in 100% by weight of all the resin components in the insulating sheet

*2 The amount in 100% by volume of the insulating sheet

*3 Measured with a rotating dynamic viscoelasticity measuring apparatus

(Examples 22 to 24)

Except that the kinds and amounts of the compounds were changed as shown in the following Table 4, insulating materials were prepared in the same manner as in Example 1 and insulating sheets each were prepared on the PET film.

(Evaluations on insulating sheets of Examples 22 to 24)

Each insulating sheet was evaluated on the aforementioned evaluation items (1) to (10) in the same manner as in Examples 2 to 21 and Comparative Examples 1 to 3.

Table 4 shows the results.

[Table 4]

| | | | Examples | | |
|---|---|---|---|---|---|
| | | | 22 | 23 | 24 |
| Components (parts by weight) | Polymer (A) | Bisphenol A phenoxy resin | 4 | 4 | 12 |
| | | Highly heat-resistant phenoxy resin | | | |
| | | Epoxy group-containing styrene resin | | | |
| | Polymer other than polymer (A) | Epoxy group-containing acrylic resin | | | |
| | Epoxy resin (B1) | Bisphenol A liquid epoxy resin | 2 | 2 | 6 |
| | | Bisphenol F liquid epoxy resin | | | |
| | | Trifunctional glycidyl diamine liquid epoxy resin | | | |
| | | Fluorene skeleton epoxy resin | | | |
| | | Naphthalene skeleton liquid epoxy resin | | | |
| | | Hexahydrophthalate skeleton liquid epoxy resin | 0.5 | 0.5 | 1.5 |
| | | Bisphenol A solid epoxy resin | | | |
| | Oxetane resin (B2) | Benzene-skeleton containing oxetane resin | | | |
| | Curing agent (C) | Alicyclic skeleton acid anhydride | 2 | 2 | 6 |
| | | Aromatic skeleton acid anhydride | | | |
| | | Polyalicyclic skeleton acid anhydride | | | |
| | | Terpene skeleton acid anhydride | | | |
| | | Biphenyl skeleton phenol resin | | | |
| | | Allyl skeleton phenol resin | | | |
| | | Triazine skeleton phenol resin | | | |
| | | Melamine skeleton phenol resin | | | |
| | | Isocyanurate-modified solid dispersed imidazole | 0.5 | 0.5 | 1.5 |
| | Magnesium carbonate anhydrous (D1) | 6-μm spherical synthetic magnesite A | 65 | | |
| | | 21-μm spherical synthetic magnesite A | 25 | | |
| | | 6-μm spherical synthetic magnesite B | | 65 | |
| | | 21-μm spherical synthetic magnesite B | | 25 | |
| | Coated body (D2) | 6-μm spherical silica-coated synthetic magnesite | | | 70 |
| | Filler other than substance (D) | 1.1-μm Magnesium oxide | | | |
| | | 9-μm crystal water-containing magnesium carbonate | | | |
| | Additive | Epoxy silane coupling agent | 1 | 1 | 3 |
| | Solvent | Methylethyl ketone | 20 | 20 | 20 |
| Amount of polymer (A) (% by weight) *1 | | | 40 | 40 | 40 |
| Amount of resin (B) (% by weight) *1 | | | 25 | 25 | 25 |
| Amount of curing agent (C) (% by weight) *1 | | | 25 | 25 | 25 |
| Amount of substance (D) (% by volume) *2 | | | 78 | 78 | 69 |
| Evaluation | Handleability | | ○ | ○ | ○ |
| | Sheet property after storage | | ○ | ○ | ○ |
| | Glass transition temperature (℃) | | 12 | 11 | 12 |
| | Thermal conductivity (W/m•K) | | 3.8 | 3.8 | 2 |
| | Dielectric breakdown voltage (kV/mm) | | 58 | 72 | 82 |
| | Solder heat resistance (288℃) | | ○ | ○ | ○ |
| | Acid resistance | | ○ | ○ | ○ |
| | Processability | | ○ | ○ | ○ |
| | Bending modulus at 25℃ of uncured insulating sheet (MPa) | | 270 | 260 | 80 |
| | Bending modulus at 25℃ of cured product of insulating sheet (MPa) | | 26000 | 25000 | 11000 |
| | tan$\delta$ at 25℃ of uncured insulating sheet *3 | | 0.4 | 0.5 | 0.5 |
| | Maximum value of tan$\delta$ at 25℃ to 250℃ of uncured insulating sheet *3 | | 1.5 | 1.6 | 1.9 |

*1 The amount in 100% by weight of all the resin components in the insulating sheet

*2 The amount in 100% by volume of the insulating sheet

*3 Measured with a rotating dynamic viscoelasticity measuring apparatus

(Examples 25 to 32)

Except that the kinds and amounts of the compounds were changed as shown in the following Table 5, insulating materials were prepared in the same manner as in Example 1 and insulating sheets each were prepared on the PET film.

(Evaluations on insulating sheets of Examples 25 to 32)

Each insulating sheet was evaluated on the aforementioned evaluation items (1) to (10) in the same manner as in Examples 2 to 21 and Comparative Examples 1 to 3.

Table 5 shows the results.

[Table 5]

| | | | Examples | | | | | | | |
|---|---|---|---|---|---|---|---|---|---|---|
| | | | 25 | 26 | 27 | 28 | 29 | 30 | 31 | 32 |
| Components (parts by weight) | Polymer (A) | Bisphenol A phenoxy resin | 4 | 4 | 4 | 4 | 4 | 4 | 4 | 4 |
| | | Highly heat-resistant phenoxy resin | | | | | | | | |
| | | Epoxy group-containing styrene resin | | | | | | | | |
| | Polymer other than polymer (A) | Epoxy group-containing acrylic resin | | | | | | | | |
| | Epoxy resin (B1) | Bisphenol A liquid epoxy resin | 2 | 2 | 2 | 2 | 2 | 2 | 2 | 2 |
| | | Bisphenol F liquid epoxy resin | | | | | | | | |
| | | Trifunctional glycidyl diamine liquid epoxy resin | | | | | | | | |
| | | Fluorene skeleton epoxy resin | | | | | | | | |
| | | Naphthalene skeleton liquid epoxy resin | | | | | | | | |
| | | Hexahydrophthalate skeleton liquid epoxy resin | 0.5 | 0.5 | 0.5 | 0.5 | 0.5 | 0.5 | 0.5 | 0.5 |
| | | Bisphenol A solid epoxy resin | | | | | | | | |
| | Oxetane resin (B2) | Benzene-skeleton containing oxetane resin | | | | | | | | |
| | Curing agent (C) | Alicyclic skeleton acid anhydride | 2 | 2 | 2 | 2 | 2 | 2 | 2 | 2 |
| | | Aromatic skeleton acid anhydride | | | | | | | | |
| | | Polyalicyclic skeleton acid anhydride | | | | | | | | |
| | | Terpene skeleton acid anhydride | | | | | | | | |
| | | Biphenyl skeleton phenol resin | | | | | | | | |
| | | Allyl skeleton phenol resin | | | | | | | | |
| | | Triazine skeleton phenol resin | | | | | | | | |
| | | Melamine skeleton phenol resin | | | | | | | | |
| | | Isocyanurate-modified solid dispersed imidazole | 0.5 | 0.5 | 0.5 | 0.5 | 0.5 | 0.5 | 0.5 | 0.5 |
| | Magnesium carbonate anhydrous (D1) | 6-μm substantially polyhedral synthetic magnesite | 50 | 50 | 50 | 50 | 50 | 50 | 50 | 20 |
| | | 21-μm substantially polyhedral synthetic magnesite | 20 | 20 | 20 | 20 | 20 | 20 | 20 | 10 |
| | Coated body (D2) | 6-μm acrylic resin-coated synthetic magnesite | | | | | | | | |
| | | 6-μm silicone resin-coated synthetic magnesite | | | | | | | | |
| | | 6-μm silica-coated synthetic magnesite | | | | | | | | |
| | Filler other than substance (D) (Inorganic filler(G)) | 1.1-μm Magnesium oxide | 20 | | | | | | | |
| | | 9-μm crystal water-containing magnesium carbonate | | | | | | | | |
| | | 0.4-μm spherical alumina | | 20 | | | | | | 60 |
| | | 30-μm spherical aluminum nitride | | | 20 | | | | | |
| | | 8-μm plate boron nitride | | | | 20 | | | | |
| | | 0.7-μm plate silicon carbide | | | | | 20 | | | |
| | | 20-μm crystalline silica | | | | | | 20 | | |
| | | 15-μm amorphous silica | | | | | | | 20 | |
| | Additive | Epoxy silane coupling agent | 1 | 1 | 1 | 1 | 1 | 1 | 1 | 1 |
| | Solvent | Methylethyl ketone | 20 | 20 | 20 | 20 | 20 | 20 | 20 | 20 |
| Amount of polymer (A) (% by weight) *1 | | | 40 | 40 | 40 | 40 | 40 | 40 | 40 | 40 |
| Amount of resin (B) (% by weight) *1 | | | 25 | 25 | 25 | 25 | 25 | 25 | 25 | 25 |
| Amount of curing agent (C) (% by weight) *1 | | | 25 | 25 | 25 | 25 | 25 | 25 | 25 | 25 |
| Amount of substance (D) (% by volume) *2 | | | 62 | 63 | 61 | 57 | 62 | 59 | 59 | 23 |
| Amount of inorganic filler (G) (% by volume) *2 | | | 15 | 14 | 17 | 22 | 16 | 19 | 20 | 46 |
| Amount of substantially polyhedral filler (% by volume) *3 | | | - | - | - | 72 | 79 | - | - | - |
| Amount of plate filler (% by volume) *3 | | | - | - | - | 28 | 21 | - | - | - |
| Evaluation | Handleability | | O | O | O | O | O | O | O | O |
| | Sheet property after storage | | O | O | O | O | O | O | O | O |
| | Glass transition temperature (°C) | | 13 | 12 | 13 | 13 | 14 | 13 | 13 | 12 |
| | Thermal conductivity (W/m•K) | | 4.4 | 4.2 | 4.8 | 4.5 | 4.7 | 4.1 | 4 | 3.5 |
| | Dielectric breakdown voltage (kV/mm) | | 58 | 60 | 42 | 70 | 40 | 58 | 62 | 72 |
| | Solder heat resistance (288°C) | | O | O | O | O | O | O | O | O |
| | Acid resistance | | O | O | O | O | O | O | O | O |
| | Processability | | O | O | O | O | O | O | O | O |
| | Bending modulus at 25°C of uncured insulating sheet (MPa) | | 350 | 330 | 320 | 380 | 310 | 350 | 290 | 210 |
| | Bending modulus at 25°C of cured product of insulating sheet (MPa) | | 29000 | 28000 | 2800 | 30000 | 31000 | 29000 | 26000 | 23000 |
| | $\tan\delta$ at 25°C of uncured insulating sheet *4 | | 0.3 | 0.3 | 0.3 | 0.2 | 0.2 | 0.3 | 0.4 | 0.4 |
| | Maximum value of $\tan\delta$ at 25°C to 250°C of uncured insulating sheet *4 | | 1.3 | 1.4 | 1.4 | 1.2 | 1.1 | 1.3 | 1.6 | 1.7 |

*1 The amount in 100% by weight of all the resin components in the insulating sheet
*2 The amount in 100% by volume of the insulating sheet
*3 The amount in 100% by weight of all the fillers in the insulating sheet
*4 Measured with a rotating dynamic viscoelasticity measuring apparatus

(Examples 33 to 44 and Comparative Example 4)

Except that the kinds and amounts of the compounds were changed as shown in the following Tables 6 and 7, insulating materials were prepared in the same manner as in Example 1 and insulating sheets each were prepared on the PET film.

(Evaluations on insulating sheets of Examples 33 to 44 and Comparative Example 4)

Each insulating sheet was evaluated on the aforementioned evaluation items (1) to (10) in the same manner as in Examples 2 to 21 and Comparative Examples 1 to 3.
Tables 6 and 7 show the results.
[Table 6]

| | | | Examples | | | | | | | |
|---|---|---|---|---|---|---|---|---|---|---|
| | | | 33 | 34 | 35 | 36 | 37 | 38 | 39 | 40 |
| Components (parts by weight) | Polymer (A) | Bisphenol A phenoxy resin | 4 | 5 | 5 | 9 | 3 | 3 | 5 | 5 |
| | | Highly heat-resistant phenoxy resin | | | | | | | | |
| | | Epoxy group-containing styrene resin | | | | | | | | |
| | Polymer other than polymer (A) | Epoxy group-containing acrylic resin | | | | | | | | |
| | Epoxy resin (B1) | Bisphenol A liquid epoxy resin | 2 | 3 | 3 | 5 | 1.5 | 1.5 | 3 | 3 |
| | | Bisphenol F liquid epoxy resin | | | | | | | | |
| | | Trifunctional glycidyl diamine liquid epoxy resin | | | | | | | | |
| | | Fluorene skeleton epoxy resin | | | | | | | | |
| | | Naphthalene skeleton liquid epoxy resin | | | | | | | | |
| | | Hexahydrophthalate skeleton liquid epoxy resin | 0.5 | 0.5 | 0.5 | 1 | 0.5 | 0.5 | 0.5 | 0.5 |
| | | Bisphenol A solid epoxy resin | | | | | | | | |
| | Oxetane resin (B2) | Benzene-skeleton containing oxetane resin | | | | | | | | |
| | Curing agent (C) | Alicyclic skeleton acid anhydride | 2 | 2 | 2 | 3 | 1 | 1 | 2 | 2 |
| | | Aromatic skeleton acid anhydride | | | | | | | | |
| | | Polyalicyclic skeleton acid anhydride | | | | | | | | |
| | | Terpene skeleton acid anhydride | | | | | | | | |
| | | Biphenyl skeleton phenol resin | | | | | | | | |
| | | Allyl skeleton phenol resin | | | | | | | | |
| | | Triazine skeleton phenol resin | | | | | | | | |
| | | Melamine skeleton phenol resin | | | | | | | | |
| | | Isocyanurate-modified solid dispersed imidazole | 0.5 | 0.5 | 0.5 | 1 | 0.5 | 0.5 | 0.5 | 0.5 |
| | Magnesium carbonate anhydrous (D1) | 6-µm substantially polyhedral synthetic magnesite | 50 | 65 | 60 | 60 | 60 | 60 | 60 | 60 |
| | | 21-µm substantially polyhedral synthetic magnesite | 20 | 20 | 18 | 10 | 24 | 24 | 18 | 18 |
| | Coated body (D2) | 6-µm acrylic resin-coated synthetic magnesite | | | | | | | | |
| | | 6-µm silicone resin-coated synthetic magnesite | | | | | | | | |
| | | 6-µm silica-coated synthetic magnesite | | | | | | | | |
| | Filler other than substance (D) (Inorganic filler (G)) | 1.1-µm Magnesium oxide | | | | | | | | |
| | | 9-µm crystal water-containing magnesium carbonate | | | | | | | | |
| | | 0.4-µm spherical alumina | | | | | | | | |
| | | 30-µm spherical aluminum nitride | | | | | | | | |
| | | 8-µm plate boron nitride | | 3 | 10 | 10 | 10 | 10 | 10 | 10 |
| | | 0.7-µm plate silicon carbide | | | | | | | | |
| | | 20-µm crystalline silica | | | | | | | | |
| | | 15-µm amorphous silica | | | | | | | | |
| | | 2-µm plate alumina | 20 | | | | | | | |
| | Dispersant (F) | Acrylic dispersant | | | | | 0.5 | | 1 | |
| | | Polyether dispersant | | | | | | 0.5 | | 1 |
| | Dispersant other than dispersant (F) | Nonion dispersant | | | | | | | | |
| | Additive | Epoxy silane coupling agent | 1 | 1 | 1 | 1 | | | | |
| | Solvent | Methylethyl ketone | 20 | 20 | 20 | 20 | 20 | 20 | 20 | 20 |
| Amount of polymer (A) (% by weight) *1 | | | 40 | 42 | 42 | 45 | 43 | 43 | 42 | 42 |
| Amount of resin (B) (% by weight) *1 | | | 25 | 29 | 29 | 30 | 29 | 29 | 29 | 29 |
| Amount of curing agent (C) (% by weight) *1 | | | 25 | 21 | 21 | 20 | 21 | 21 | 21 | 21 |
| Amount of substance (D) (% by volume) *2 | | | 63 | 71 | 64 | 52 | 75 | 75 | 64 | 64 |
| Amount of inorganic filler (G) (% by volume) *2 | | | 14 | 3 | 11 | 10 | 12 | 12 | 11 | 11 |
| Amount of substantially polyhedral filler (% by volume) *3 | | | 82 | 96 | 85 | 84 | 86 | 86 | 85 | 85 |
| Amount of plate filler (% by volume) *3 | | | 18 | 4 | 15 | 16 | 14 | 14 | 15 | 15 |
| Evaluation | Handleability | | ○ | ○ | ○ | ○ | ○ | ○ | ○ | ○ |
| | Sheet property after storage | | ○ | ○ | ○ | ○ | ○ | ○ | ○ | ○ |
| | Glass transition temperature (°C) | | 10 | 9 | 8 | 7 | 8 | 8 | 8 | 8 |
| | Thermal conductivity (W/m•K) | | 4.4 | 3.8 | 5 | 3.8 | 7.2 | 6.8 | 5 | 5 |
| | Dielectric breakdown voltage (kV/mm) | | 60 | 40 | 82 | 110 | 60 | 56 | 102 | 92 |
| | Solder heat resistance (288°C) | | ○ | ○ | ○ | ○ | ○ | ○ | ○ | ○ |
| | Acid resistance | | ○ | ○ | ○ | ○ | ○ | ○ | ○ | ○ |
| | Processability | | ○ | ○ | ○ | ○ | ○ | ○ | ○ | ○ |
| | Bending modulus at 25°C of uncured insulating sheet (MPa) | | 300 | 280 | 250 | 60 | 500 | 550 | 150 | 170 |
| | Bending modulus at 25°C of cured product of insulating sheet (MPa) | | 27000 | 26000 | 24000 | 7000 | 35000 | 37000 | 16000 | 18000 |
| | tan$\delta$ at 25°C of uncured insulating sheet *4 | | 0.4 | 0.5 | 0.4 | 0.7 | 0.1 | 0.1 | 0.4 | 0.3 |
| | Maximum value of tan$\delta$ at 25°C to 250°C of uncured insulating sheet *4 | | 1.4 | 1.5 | 1.4 | 1.6 | 1.1 | 1 | 1.5 | 1.5 |

*1 The amount in 100% by weight of all the resin components in the insulating sheet
*2 The amount in 100% by volume of the insulating sheet
*3 The amount in 100% by weight of all the fillers in the insulating sheet
*4 Measured with a rotating dynamic viscoelasticity measuring apparatus

[Table 7]

| | | | Examples | | | | Comp. Exs. |
|---|---|---|---|---|---|---|---|
| | | | 41 | 42 | 43 | 44 | 4 |
| Components (parts by weight) | Polymer (A) | Bisphenol A phenoxy resin | | | | 6 | 9.75 |
| | | Highly heat-resistant phenoxy resin | | | | | |
| | | Epoxy group-containing styrene resin | | | | | |
| | | Carboxyl-group containing acrylic resin | 6 | | | | |
| | | Sulfonic-acid-group containing styrene resin | | 6 | | | |
| | | Phosphate-group containing acrylic resin | | | 6 | | |
| | Polymer other than polymer (A) | Epoxy group-containing acrylic resin | | | | | |
| | Epoxy resin (B1) | Bisphenol A liquid epoxy resin | 3 | 3 | 3 | | |
| | | Bisphenol F liquid epoxy resin | | | | | |
| | | Trifunctional glycidyl diamine liquid epoxy resin | | | | | |
| | | Fluorene skeleton epoxy resin | | | | | |
| | | Naphthalene skeleton liquid epoxy resin | | | | | |
| | | Hexahydrophthalate skeleton liquid epoxy resin | 0.75 | 0.75 | 0.75 | 0.75 | |
| | | Bisphenol A solid epoxy resin | | | | | |
| | | Distilled bisphenol A liquid epoxy resin | | | | 3 | |
| | Oxetane resin (B2) | Benzene-skeleton containing oxetane resin | | | | | |
| | Curing agent (C) | Alicyclic skeleton acid anhydride | 3 | 3 | 3 | 3 | 3 |
| | | Aromatic skeleton acid anhydride | | | | | |
| | | Polyalicyclic skeleton acid anhydride | | | | | |
| | | Terpene skeleton acid anhydride | | | | | |
| | | Biphenyl skeleton phenol resin | | | | | |
| | | Allyl skeleton phenol resin | | | | | |
| | | Triazine skeleton phenol resin | | | | | |
| | | Melamine skeleton phenol resin | | | | | |
| | | Isocyanurate-modified solid dispersed imidazole | 0.75 | 0.75 | 0.75 | 0.75 | 0.75 |
| | Magnesium carbonate anhydrous (D1) | 6-μm substantially polyhedral synthetic magnesite | 65 | 65 | 65 | 65 | 65 |
| | | 21-μm substantially polyhedral synthetic magnesite | 20 | 20 | 20 | 20 | 20 |
| | Coated body (D2) | 6-μm acrylic resin-coated synthetic magnesite | | | | | |
| | | 6-μm silicone resin-coated synthetic magnesite | | | | | |
| | | 6-μm silica-coated synthetic magnesite | | | | | |
| | Filler other than substance (D) (Inorganic filler (G)) | 1.1-μm Magnesium oxide | | | | | |
| | | 9-μm crystal water-containing magnesium carbonate | | | | | |
| | | 0.4-μm spherical alumina | | | | | |
| | | 30-μm spherical aluminum nitride | | | | | |
| | | 8-μm plate boron nitride | | | | | |
| | | 0.7-μm plate silicon carbide | | | | | |
| | | 20-μm crystalline silica | | | | | |
| | | 15-μm amorphous silica | | | | | |
| | Additive | Epoxy silane coupling agent | 1.5 | 1.5 | 1.5 | 1.5 | 1.5 |
| | Solvent | Methylethyl ketone | 20 | 20 | 20 | 20 | 20 |
| Amount of polymer (A) (% by weight) *1 | | | 40 | 40 | 40 | 40 | 65 |
| Amount of resin (B) (% by weight) *1 | | | 25 | 25 | 25 | 25 | — |
| Amount of curing agent (C) (% by weight) *1 | | | 25 | 25 | 25 | 25 | 25 |
| Amount of substance (D) (% by volume) *2 | | | 69 | 69 | 69 | 69 | 69 |
| Amount of inorganic filler (G) (% by volume) *2 | | | — | — | — | — | — |
| Evaluation | Handleability | | ○ | ○ | ○ | ◎ | × |
| | Sheet property after storage | | △ | △ | △ | ◎ | × |
| | Glass transition temperature (°C) | | 9 | 9 | 9 | 1 | 29 |
| | Thermal conductivity (W/m•K) | | 3.7 | 3.5 | 3.8 | 3.1 | 1.9 |
| | Dielectric breakdown voltage (kV/mm) | | 72 | 60 | 84 | 45 | 41 |
| | Solder heat resistance (288°C) | | ○ | ○ | ○ | ○ | × |
| | Acid resistance | | ○ | ○ | ○ | ○ | ○ |
| | Processability | | ○ | ○ | ○ | ○ | ○ |
| | Bending modulus at 25°C of uncured insulating sheet (MPa) | | 210 | 220 | 200 | 70 | 510 |
| | Bending modulus at 25°C of cured product of insulating sheet (MPa) | | 20000 | 21000 | 19000 | 26000 | 700 |
| | tan $\delta$ at 25°C of uncured insulating sheet *3 | | 0.4 | 0.4 | 0.5 | 0.5 | 0.1 |
| | Maximum value of tan $\delta$ at 25°C to 250°C of uncured insulating sheet *3 | | 1.5 | 1.4 | 1.5 | 1.6 | 1.1 |

*1 The amount in 100% by weight of all the resin components in the insulating sheet

*2 The amount in 100% by volume of the insulating sheet

*3 Measured with a rotating dynamic viscoelasticity measuring apparatus

**Explanation of Symbols**

1 Multilayer structure
2 Heat conductor
2a One side
2b The other side
3 Insulating layer
4 Electrically conductive layer

## Claims

1. An insulating sheet used for bonding a heat conductor having a thermal conductivity of 10 W/m·K or higher to an electrically conductive layer, comprising:

   (A) a polymer having a weight average molecular weight of 10,000 or more;
   (B) at least one of an epoxy resin (B1) having a weight average molecular weight of less than 10,000 and an oxetane resin (B2) having a weight average molecular weight of less than 10,000;
   (C) a curing agent; and
   (D) at least one of magnesium carbonate anhydrous (D1) represented by $MgCO_3$ and containing no crystal water and a coated body (D2) obtainable by coating the surface of the magnesium carbonate anhydrous (D1) with an organic resin, a silicone resin, or silica.

2. The insulating sheet according to claim 1, further comprising

   (G) an inorganic filler other than the substance (D).

3. The insulating sheet according to claim 1 or 2,
wherein
the inorganic filler (G) is at least one substance selected from the group consisting of alumina, silica, boron nitride, aluminum nitride, silicon nitride, silicon carbide, zinc oxide, magnesium oxide, talc, mica, and hydrotalcite.

4. The insulating sheet according to any one of claims 1 to 3,
wherein
the polymer (A) has an aromatic skeleton and a weight average molecular weight of 30,000 or more.

5. The insulating sheet according to any one of claims 1 to 4,
wherein
the curing agent (C) is a phenol resin, or an acid anhydride having an aromatic skeleton or an alicyclic skeleton, a hydrogenated product of the acid anhydride, or a modified product of the acid anhydride.

6. The insulating sheet according to any one of claims 1 to 5,
wherein
the resin (B) contains at least one of an epoxy monomer (B1b) having an aromatic skeleton and a weight average molecular weight of 600 or less and an oxetane monomer (B2b) having an aromatic skeleton and a weight average molecular weight of 600 or less.

7. The insulating sheet according to any one of claims 1 to 6,
wherein
the insulating sheet contains 20 to 60% by weight of the polymer (A) and 10 to 60% by weight of the monomer (B) in 100% by weight of all resin components including the polymer (A), the monomer (B), and the curing agent (C) so that the total amount of the polymer (A) and the monomer (B) is less than 100% by weight,
when the insulating sheet is uncured, the insulating sheet has a glass transition temperature of 25°C or lower.

8. The insulating sheet according to any one of claims 1 to 7,
wherein

the substance (D) is at least one substance (Dd1) of spherical magnesium carbonate anhydrous (D1d1) represented by $MgCO_3$ and containing no crystal water and a coated body (D2d1) obtainable by coating the surface of the spherical magnesium carbonate anhydrous (D1d1) with an organic resin, a silicone resin, or silica.

**9.** The insulating sheet according to any one of claims 2 to 7,
wherein
the substance (D) is at least one substance (Dd2) of substantially-polyhedral magnesium carbonate anhydrous (D1d2) represented by $MgCO_3$ and containing no crystal water and a coated body (D2d2) obtainable by coating the surface of the substantially-polyhedral magnesium carbonate anhydrous (D1d2) with an organic resin, a silicone resin, or silica,
the insulating sheet further comprises an inorganic filler (G) other than the substance (D) and the inorganic filler (G) is a plate filler.

**10.** The insulating sheet according to claim 9, wherein
the substance (Dd2) has an average particle size in the range of 0.1 to 40 μm and the plate filler has the average length of 0.1 to 10 μm.

**11.** The insulating sheet according to claim 9 or 10, wherein
the insulating sheet contains the substance (Dd2) and the plate filler at a volume ratio of 70:30 to 99:1, and
the total amount of the substance (Dd2) and the plate filler contained in the insulating sheet is 60 to 90% by volume.

**12.** The insulating sheet according to any one of claims 9 to 11,
wherein
the plate filler is at least one of alumina and boron nitride.

**13.** The insulating sheet according to any one of claims 1 to 12, further comprising

(F) a dispersant having a hydrogen-bonding functional group containing a hydrogen atom.

**14.** The insulating sheet according to claim 13,
wherein
the hydrogen-bonding functional group containing a hydrogen atom in the dispersant (F) has a pKa of 2 to 10.

**15.** The insulating sheet according to any one of claims 1 to 14,
wherein
the polymer (A) has a hydrogen-bonding functional group containing a hydrogen atom.

**16.** The insulating sheet according to claim 15,
wherein
the hydrogen-bonding functional group containing a hydrogen atom in the polymer (A) has a pKa of 2 to 10.

**17.** The insulating sheet according to claim 15 or 16,
wherein
the hydrogen-bonding functional group containing a hydrogen atom in the polymer (A) is at least one functional group selected from the group consisting of a phosphate group, a carboxyl group, and a sulfonate group.

**18.** The insulating sheet according to any one of claims 1 to 17,
wherein
the polymer (A) is a phenoxy resin.

**19.** The insulating sheet according to claim 18,
wherein
the phenoxy resin has a glass transition temperature of 95˚C or higher.

**20.** The insulating sheet according to any one of claims 5 to 19,
wherein
the curing agent (C) is a first acid anhydride having a polyalicyclic skeleton, a hydrogenated product of the first acid anhydride, or a modified product of the first acid anhydride, or a second acid anhydride having an alicyclic skeleton

formed by addition reaction between a terpene compound and maleic anhydride, a hydrogenated product of the second acid anhydride, or a modified product of the second acid anhydride.

**21.** The insulating sheet according to claim 20, wherein the curing agent (C) is an acid anhydride represented by any one of formulas (1) to (3):

[Chem. 1]

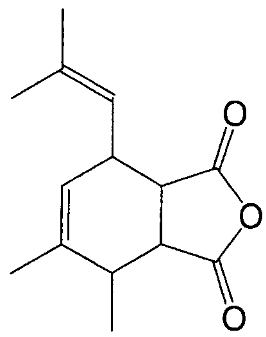

(1)

[Chem. 2]

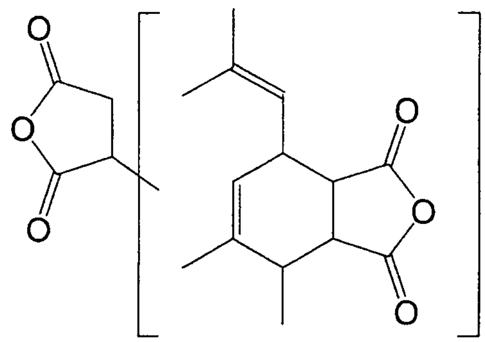

(2)

[Chem. 3]

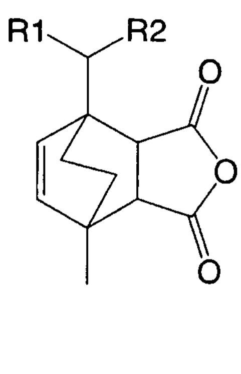

(3)

wherein R1 and R2 each represent hydrogen, a C1-C5 alkyl group, or a hydroxy group.

**22.** The insulating sheet according to any one of claims 5 to 19,
wherein
the curing agent (C) is a phenol resin having a melamine skeleton or a triazine skeleton, or a phenol resin having an allyl group.

**23.** The insulating sheet according to any one of claims 1 to 22,
wherein
the resin (B) has a hydroxy group equivalent of 6000 or more.

**24.** The insulating sheet according to any one of claims 1 to 23,
wherein
when the insulating sheet is uncured, the insulating sheet has a glass transition temperature of 25˚C or lower and a bending modulus at 25˚C of 10 to 1,000 MPa,
after the insulating sheet is cured, a cured product of the insulating sheet has a bending modulus at 25˚C of 1,000 to 50,000 MPa, and
when the insulating sheet is uncured, the insulating sheet has a tanδ of 0.1 to 1.0 at 25˚C, and when the uncured insulating sheet is heated from 25˚C to 250˚C, the insulating sheet has a maximum tanδ of 1.0 to 5.0, each of the tanδ measured with a rotating dynamic viscoelasticity measuring apparatus.

**25.** A multilayer structure, comprising:

a heat conductor having a thermal conductivity of 10 W/m·K or higher;
an insulating layer laminated on at least one side of the heat conductor; and
an electrically conductive layer laminated on the insulating layer on the other side of the insulating sheet,
wherein
the insulating layer is formed by curing the insulating sheet according to any one of claims 1 to 24.

**26.** The multilayer structure according to claim 25, wherein
the heat conductor is made of a metal.

[FIG. 1]

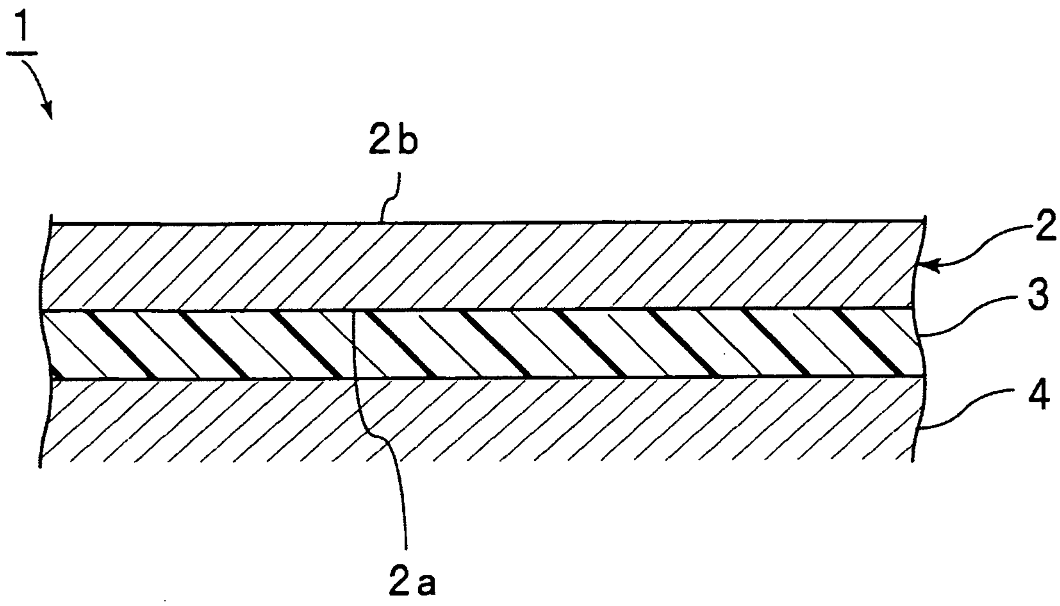

## INTERNATIONAL SEARCH REPORT

International application No.
PCT/JP2009/063794

A. CLASSIFICATION OF SUBJECT MATTER
H01B17/56(2006.01)i, B32B15/08(2006.01)i, H01B17/62(2006.01)i

According to International Patent Classification (IPC) or to both national classification and IPC

B. FIELDS SEARCHED

Minimum documentation searched (classification system followed by classification symbols)
H01B17/56, B32B15/08, H01B17/62

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2007-116134 A (Toray Industries, Inc.), 10 May, 2007 (10.05.07), Claim 1; Par. Nos. [0037] to [0053] (Family: none) | 1-26 |
| A | JP 10-242606 A (Hitachi Chemical Co., Ltd.), 11 September, 1998 (11.09.98), (Family: none) | 1-26 |
| P,A | JP 2009-031536 A (Sekisui Chemical Co., Ltd.), 12 March, 2009 (12.03.09), (Family: none) | 1-26 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>31 August, 2009 (31.08.09) | Date of mailing of the international search report<br>08 September, 2009 (08.09.09) |
| Name and mailing address of the ISA/<br>Japanese Patent Office<br>Facsimile No. | Authorized officer<br><br>Telephone No. |

Form PCT/ISA/210 (second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006342238 A
- JP H08332696 A

### Non-patent literature cited in the description

- *Adhesion,* 1996, vol. 40 (8), 342-350